# EUROPEAN PATENT APPLICATION

(11) **EP 4 654 775 A1**
(43) Date of publication of application: **26.11.2025**
(21) Application number: 25165284.8
(22) Date of filing: 21.03.2025
(51) Int. Cl.: H10B 41/10, H10B 41/27, H10B 43/10, H10B 43/27

(54) **SEMICONDUCTOR DEVICES AND DATA STORAGE SYSTEMS INCLUDING THE SAME**

(30) Priority: 24.05.2024 KR 20240067712
(71) Applicant: Samsung Electronics Co., Ltd., Suwon-si, Gyeonggi-do 16677 (KR)
(72) Inventor: KIM, Jinhyuk, 16677 Suwon-si, Gyeonggi-do (KR); KIM, Pyeongwoo, 16677 Suwon-si, Gyeonggi-do (KR); LEE, Jongmin, 16677 Suwon-si, Gyeonggi-do (KR); CHOI, Yitaek, 16677 Suwon-si, Gyeonggi-do (KR)
(74) Representative: Kuhnen & Wacker Patent- und Rechtsanwaltsbüro PartG mbB

(57) **Abstract**

A semiconductor device (100) according to an example embodiment may include a conductive layer (101), a stack structure (GS) including lower gate electrodes (130L), memory gate electrodes (130M), and upper gate electrodes (130U) stacked sequentially in a first direction (Z) on the conductive layer (101) and spaced apart from each other in a first region (R1a), a second region (R1b), and an extension region (R2) between the first region (R1a) and the second region (R1b), first channel structures (CHa) and second channel structures (CHb) penetrating through the stack structure (GS) and extending in the first direction (Z), respectively, in the first region (R1a) and the second region (R1b), separation regions extending in a second direction (X), the separation regions penetrating through the stack structure (GS) in the first region (R1a), the extension region (R2), and the second region (R1b), and spaced apart from each other in a third direction (Y), first insulating regions penetrating through the upper gate electrodes (130U) in each of the first and second regions (R1a, R1b) between the separation regions.

## Description

### BACKGROUND

Example embodiments of the present disclosure relates to semiconductor devices and data storage systems including the same.

As demand for high performance, high speed, and/or multi-functionality of semiconductor devices increases, the degree of integration of semiconductor devices has increased accordingly. In the process of manufacturing fine-patterned semiconductor devices in response to the trend for high integration of semiconductor devices, it is necessary to implement patterns having a fine width or a fine separation distance.

### SUMMARY

Example embodiments of the present disclosure are to provide a semiconductor device which may increase a degree of integration.

Example embodiments of the present disclosure are to provide a data storage system including a semiconductor device having an improved degree of integration.

In some example embodiments, provided is a semiconductor device including a conductive layer, a stack structure including lower gate electrodes, memory gate electrodes, and upper gate electrodes stacked sequentially in a first direction on the conductive layer and spaced apart from each other in a first region, a second region, and an extension region between the first region and the second region, the first direction being perpendicular to an upper surface of the conductive layer, first channel structures and second channel structures penetrating through the stack structure and extending in the first direction, respectively, in the first region and the second region, separation regions extending in a second direction, the second direction being perpendicular to the first direction, the separation regions penetrating through the stack structure in the first region, the extension region, and the second region, and spaced apart from each other in a third direction, the third direction being perpendicular to the first and second directions, first insulating regions penetrating through the upper gate electrodes in each of the first and second regions between the separation regions and extending in the second direction, second insulating regions separating the upper gate electrodes into first upper gate electrodes and second upper gate electrodes, and extending in the third direction between the first region and the extension region and further between the second region and the extension region, first string select contact plugs in contact with at least one of the first upper gate electrodes and electrically connected to least one of the first upper gate electrodes, respectively, in the first region, second string select contact plugs in contact with at least one of the second upper gate electrodes and electrically connected to the least one of second upper gate electrodes, respectively, in the second region, and word line contact plugs penetrating through the upper gate electrodes and electrically connected to one of the memory gate electrodes or one of the lower gate electrodes, respectively, in the extension region.

In some example embodiments, provided is a semiconductor device including a conductive layer, a stack structure including lower gate electrodes, memory gate electrodes, and upper gate electrodes stacked sequentially in a first direction on the conductive layer and spaced apart from each other in a first region, a second region, and an extension region between the first region and the second region, the first direction being perpendicular to an upper surface of the conductive layer, first channel structures and second channel structures penetrating through the stack structure and extending in the first direction, respectively, in the first region and the second region, word line contact plugs penetrating through the upper gate electrodes and electrically connected to the memory gate electrodes and the lower gate electrodes, respectively, in the extension region, and insulating regions penetrating the upper gate electrodes and separating the upper gate electrodes into a first portion in the first region, a second portion in the second region, and a third portion in the extension region, the insulating regions further penetrating between the first region and the extension region and further between the second region and the extension region. Each of the memory gate electrodes and the lower gate electrodes extend in the first region, the extension region, and the second region and are spaced apart in the first direction from the insulating regions.

In some example embodiments, provided is a data storage system including a semiconductor storage device including a first semiconductor structure including circuit elements, a second semiconductor structure on one surface of the first semiconductor structure, and an input/output pad electrically connected to the circuit elements, a controller electrically connected to the semiconductor storage device through the input/output pad and configured to control the semiconductor storage device. The second semiconductor structure includes, a conductive layer, a stack structure including lower gate electrodes, memory gate electrodes, and upper gate electrodes stacked sequentially in a first direction on the conductive layer and spaced apart from each other in a first region, a second region, and an extension region between the first region and the second region, the first direction being perpendicular to an upper surface of the conductive layer, first channel structures and second channel structures penetrating through the stack structure and extending in a second direction, respectively, in the first region and the second region, common word line contact plugs penetrating through the upper gate electrodes and electrically connected to the memory gate electrodes, respectively, in the extension region, and insulating regions penetrating the upper gate electrodes and separating the upper gate electrodes between the first region and the extension region and further between the second region and the extension region. Each of the common word line contact plugs is electrically connected to the first channel structures and the second channel structures through the connected memory gate electrode.

According to some example embodiments, in a process of forming a contact plug, contact plugs in contact with contact regions of gate electrodes may be formed without an additional staircase process to form the contact regions of the gate electrodes into a staircase shape. Accordingly, since the process of forming the contact regions of the gate electrodes into the staircase shape is omitted, memory regions may be disposed on both sides of the contact regions of the gate electrodes. Accordingly, the memory regions on both sides thereof may be simultaneously selected by the contact regions of one gate electrode, and an available area in which the memory region may be disposed may be increased, thereby improving a degree of integration of the semiconductor device.

Accordingly, semiconductor devices having an improved degree of integration and a data storage system including the same may be provided.

Advantages and effects of some example embodiments of the present disclosure are not limited to the foregoing content and may be more easily understood in the process of describing a various example embodiments of the present disclosure.

### BRIEF DESCRIPTION OF DRAWINGS

The above and other aspects, features, and advantages of some example embodiments will be more clearly understood from the following detailed description, taken in conjunction with the accompanying drawings, in which:
FIG. 1 is a schematic circuit diagram of a semiconductor device according to some example embodiments;
FIG. 2 is a schematic plan view of a semiconductor device according to some example embodiments;
FIG. 3 is a perspective view illustrating a cutting structure of the gate electrodes of FIG. 2;
FIGS. 4A to 4C are schematic cross-sectional views of a semiconductor device according to some example embodiments;
FIGS. 5A and 5B are enlarged views of partial regions of FIG. 4A;
FIGS. 6 and 7 are schematic cross-sectional views of a semiconductor device according to some example embodiments;
FIG. 8 is a schematic plan view of a semiconductor device according to some example embodiments;
FIG. 9 is a schematic cross-sectional view of a semiconductor device according to some example embodiments;
FIGS. 10A to 10K are schematic cross-sectional views illustrating a method of manufacturing a semiconductor device according to some example embodiments;
FIG. 11 is a view schematically illustrating a data storage system including a semiconductor device according to some example embodiments;
FIG. 12 is a perspective view schematically illustrating a data storage system including a semiconductor device according to an example embodiment.

### DETAILED DESCRIPTION

Hereinafter, some example embodiments of the present disclosure will be described with reference to the accompanying drawings. Hereinafter, it may be understood that the expressions such as "on," "above," "upper," "below," "beneath," "lower," and "side," merely indicated based on drawings, except that they are indicated by drawings and referred to separately.

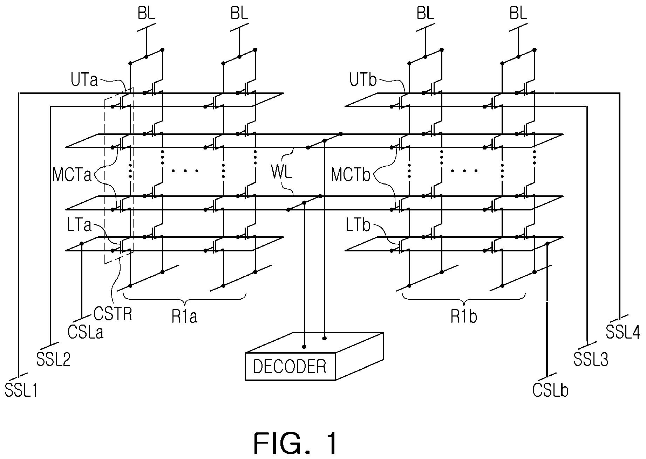

FIG. 1 is a schematic circuit diagram of a semiconductor device according to some example embodiments.

A semiconductor device 100 according to some example embodiments may include a first memory region R1a and a second memory region R1b.

Memory cell strings CSTR may be disposed in the first memory region R1a and the second memory region R1b, respectively. The memory cell strings CSTR may have a string structure in which transistors are connected in series and may define one channel structure Cha or CHb, and one memory cell string CSTR may connected to a bit line BL, a common source line CSL, word lines WL, and string select lines SSL.

Each of the memory cell strings CSTR of the first memory region R1a and the second memory region R1b may include lower transistors LTa and LTb adjacent to common source lines CSLa and CSLb, upper transistors Uta and UTb adjacent to the bit line BL, and a plurality of memory cell transistors MCTa and MCTb disposed between the lower transistors LTa and LTb and the upper transistors Uta and UTb. The number of lower transistors LTa and LTb and the number of upper transistors UTa and UTb may be variously modified according to some example embodiments.

According to some example embodiments, the upper transistors UTa and UTb may include string select transistors, and the lower transistors LTa and LTb may include ground selection transistors. The word lines WL may be gate electrodes of the memory cell transistors MCTa and MCTb, and the string select lines SSL1 to SSL4 may be gate electrodes of the upper transistors UTa and UTb, respectively.

A plurality of memory cell strings CSTR disposed in each of the first memory region R1a and the second memory region R1b may be connected to each of the bit line BL, each of the common source lines CSLa and CSLb, and each of string select lines SSL1 to SSL4. In this case, the memory cell strings CSTR of the first memory region R1a and the second memory region R1b may be commonly connected to the same word line WL on the same level and may be connected to a decoder by one contact plug.

Accordingly, when a selection signal is applied to one word line WL, the memory cell transistors MCTa and MCTb on a level connected to the corresponding word lines WL of the first memory region R1a and the second memory region R1b may receive gate voltages simultaneously. However, only the memory cell string CSTR selected by the bit line BL and string select lines SSL1 to SSL4 may be selectively driven.

In this manner, the word line WL may be connected between the first memory region R1a and the second memory region R1b so that contact plugs for each word line WL are disposed to be shared, so that the contact plugs are not individually disposed in each of the memory regions R1a and R1b, thereby increasing an available area of the memory cell strings CSTR.

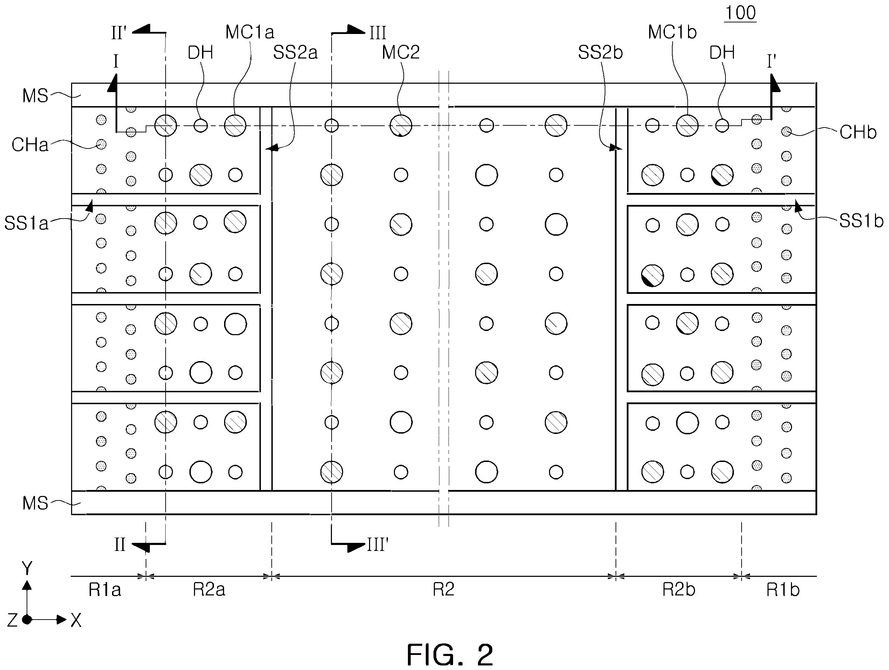

Hereinafter, a semiconductor device in which the word line contact plugs of FIG. 1 may be shared will be described with reference to FIGS. 2 to 5B.

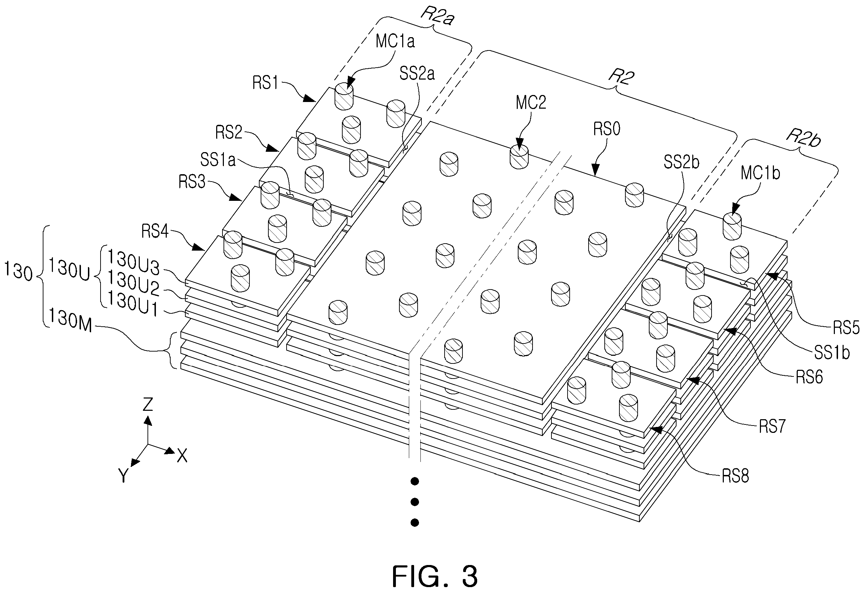

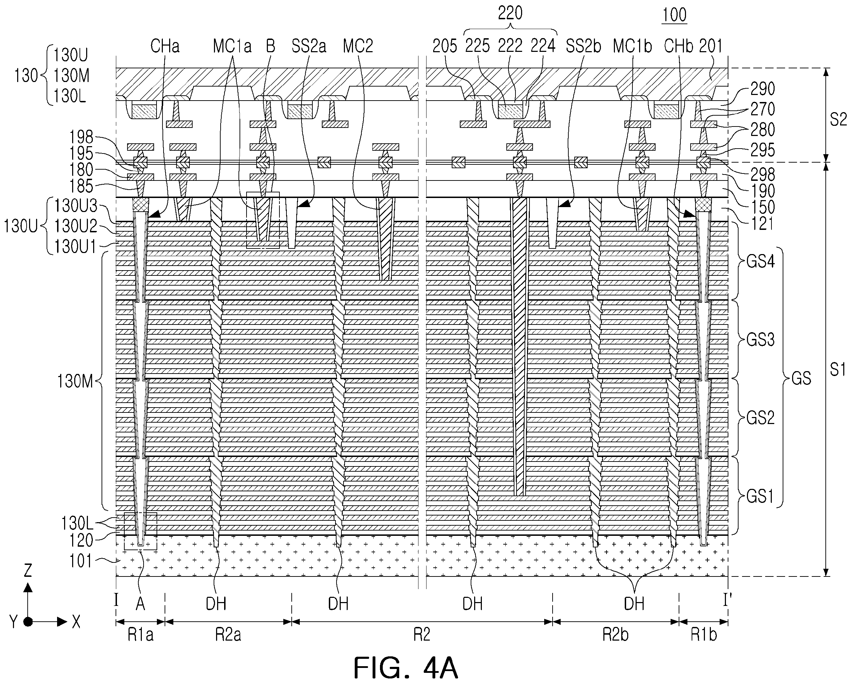

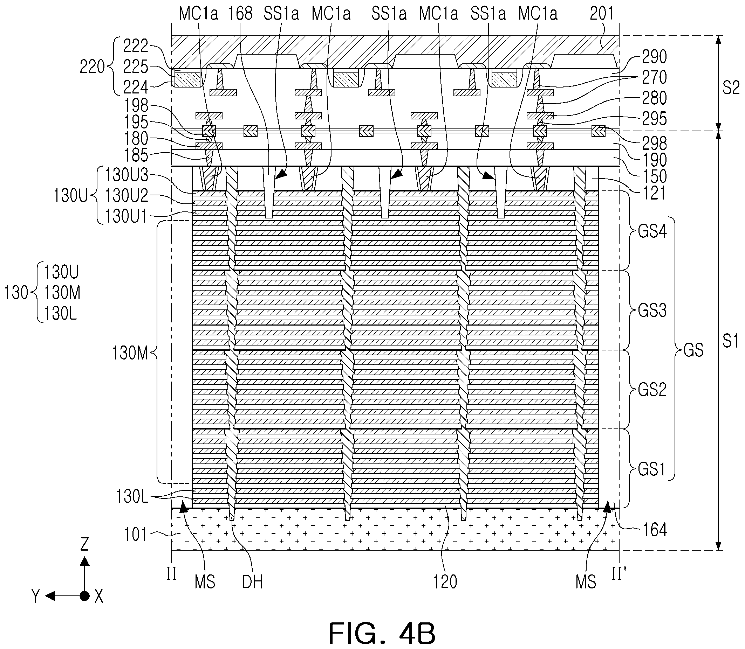

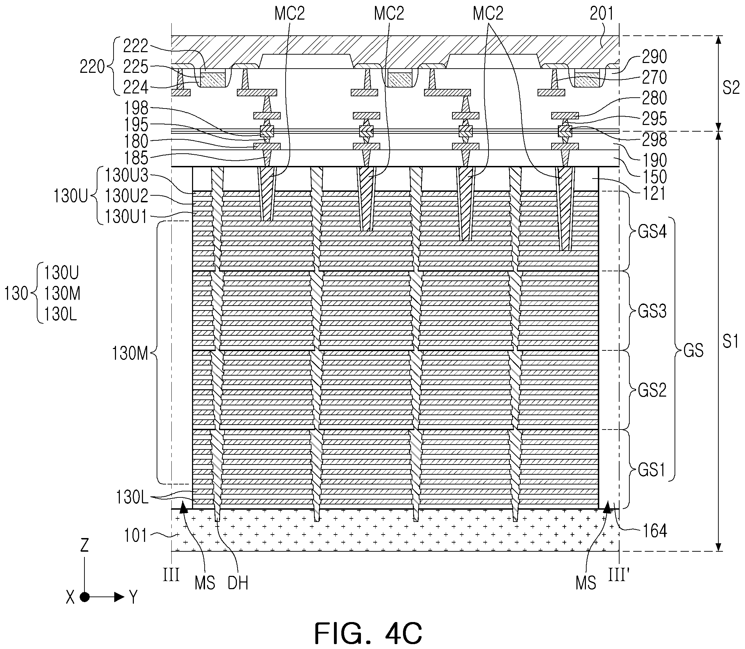

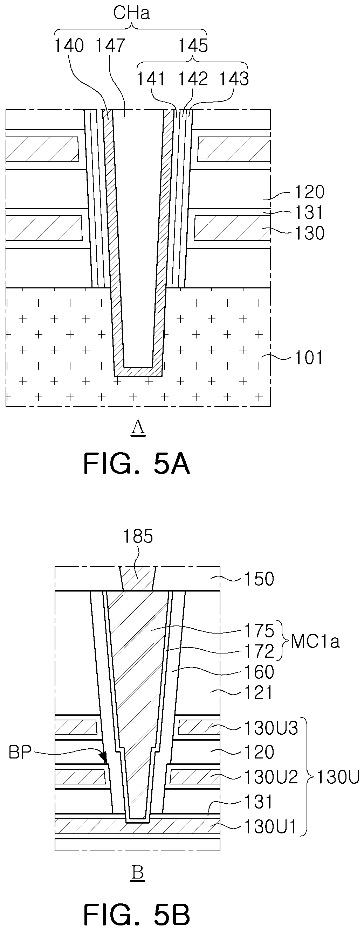

FIG. 2 is a schematic plan view of a semiconductor device according to some example embodiments, FIG. 3 is a perspective view illustrating a separation structure of the gate electrodes of FIG. 2, FIGS. 4A to 4C are schematic cross-sectional views of semiconductor devices according to some example embodiments. FIG. 4A is a cross-sectional view illustrating a region taken along line II' of the semiconductor device of FIG. 2, FIG. 4B is a cross-sectional view illustrating a region taken along line II-II' of the semiconductor device of FIG. 2, and FIG. 4C is a cross-sectional view illustrating a region taken along line III-III' of the semiconductor device of FIG. 2. FIG. 5A is a partially enlarged view illustrating region 'A' of FIG. 4A, and FIG. 5B is a partially enlarged view illustrating region 'B' of FIG. 4A.

Referring to FIGS. 2 to 5B, a semiconductor device 100 may include a first semiconductor structure S1 and a second semiconductor structure S2, and the first semiconductor structure S1 may be stacked in a Z-direction, a vertical direction, with respect to the second semiconductor structure S2. Specifically, the first semiconductor structure S1 may be disposed below the second semiconductor structure S2 in the Z-direction. In some example embodiments, conversely, the second semiconductor structure S2 may be disposed below the first semiconductor structure S1.

In some example embodiments, the semiconductor device 100 may include the first semiconductor structure S1 including a conductive layer 10, which is a common source line CSL, and the second semiconductor structure S2 in which a peripheral circuit region is formed. The second semiconductor structure S2 may form a peripheral circuit by forming transistors and metal patterns for wiring the transistors on a substrate 201. After the peripheral circuit is formed in the second semiconductor structure S2, a single semiconductor device may be formed by bonding the second semiconductor structure S2 to the first semiconductor structure S1, but example embodiments are not limited thereto.

The first semiconductor structure S1 of the semiconductor device 100 may include an extension region R2, and a first memory region R1a and a second memory region R1b on both sides of the extension region R2 in an X-direction.

The first memory region R1a and the second memory region R1b are memory cell regions in which the memory cell strings CSTR of FIG. 1 are disposed, and may be regions in which the channel structures CHa and CHb are disposed. The extension region R2 may correspond to a region for electrically connecting the channel structures CHa and CHb to the second semiconductor structures S2, and to this end, the extension region R2 may be a region in which a plurality of word line contact plugs MC2 connected to gate electrodes 130 on different levels are disposed, but example embodiments are not limited thereto.

When a plurality of mats MAT are disposed in the first memory region R1a and the second memory region R1b, the first memory region R1a and the second memory region R1b may be defined as each of the mats, but example embodiments are not limited thereto. The extension region R2 is a region disposed between the first memory region R1a and the second memory region R1b adjacent to each other, and may be a central region between the plurality of mats.

A first string select region R2a may be disposed between the first memory region R1a and the extension region R2, and a second string select region R2b may be disposed between the second memory region R1b and the extension region R2. The first string select region R2a and the second string select region R2b may be defined as regions in which string select contact plugs MC1a and MC1b are disposed to select the gate electrodes 130, string select lines, respectively.

The first semiconductor structure S1 may have a structure in which the first memory region R1a, the first string select region R2a, the extension region R2, the second string select region R2b, and the second memory region R1b are disposed sequentially in the X-direction. According to the separation of the gate electrodes 130, the first memory region R1a and the first string select region R2a may be defined as a first region, and the second string select region R2b and the second memory region R1b may be defined as a second region, and it may be defined that a first region and a second region are disposed on both sides of the extension region R2. The first semiconductor structure S1 may include a conductive layer 101, stack structures GS1 to GS4 (GS) in which the gate electrodes 130 and interlayer insulating layers 120 are alternately stacked on an upper surface of the conductive layer 101 in the first memory region R1a, the first string select region R2a, the extension region R2, the second string select region R2b and the second memory region R1b, channel structures CHa and CHb disposed in the first memory region R1a and the second memory region R1b to penetrate through the stack structures GS1 to GS4, separation regions MS extending in the X-direction by penetrating through the stack structures GS1 to GS4, and insulating regions SS penetrating through a portion of the gate electrodes 130. An interconnection structure and a passivation layer may be further included in a lower portion of the conductive layer 101.

Support structures DH and the word line contact plugs MC2 may be disposed in the extension region R2, and the support structures DH and the string select contact plugs MC1a and MC1b may be disposed in the first string select region R2a and the second string select region R2b.

As illustrated in FIGS. 2 and 4A, the first memory region R1a and the second memory region R1b may be disposed on both sides of the extension region R2 in the X-direction, and may have a structure in which the first memory region R1a and the second memory region R1b are symmetrical to each other. The first string select region R2a and the second string select region R2b may be disposed on both sides of the extension region R2 in the X-direction, and may be symmetrical to each other. Here, 'may be symmetrical' may not only denote that an arrangement has an exact mirror image, but may also include being arranged to have a functionally equivalent structure. Accordingly, 'may be symmetrical' may include point symmetry and line symmetry, and may be variously changed as long as the regions have the same number of contact plugs MC1a and MC1b and the same contact structure as the gate electrodes 130.

In FIGS. 4A to 4C, the contact plugs MC1a, MC1b and MC2 are illustrated as extending by different lengths for connection between each of the gate electrodes 130 and the contact plugs MC1a, MC1b and MC2, but example embodiments are not limited thereto.

The extension region R2, the first memory region R1a and the second memory region R1b may include a cell region insulating layer 150 on upper portions of the stack structures GS1 to GS4, and may include studs 185 penetrating through the cell region insulating layer 150 and configured for electrical connection between the channel structures CHa and CHb and the contact plugs MC1a, MC1b and MC2, an upper interconnection structure 180 above the cell region insulating layer 150, and first bonding structures 195 and 198 connected to the upper interconnection structure 180.

The conductive layer 101 may include at least one of a conductive material such as doped silicon and a conductive material such as a metal or metal nitride. However, example embodiments are not limited thereto. For example, the conductive layer 101 may include a silicon layer having an N-type conductivity type, which may be a common source.

The gate electrodes 130 may be stacked and vertically spaced apart from each other on the upper surface of the conductive layer 101, and may thus be included in the stack structures GS1, GS2, GS3 and GS4 together with interlayer insulating layers 120. The gate electrodes 130 may extend from the extension region R2 to the first memory region R1a and the second memory region R1b on both sides, but upper gate electrodes 130U may be physically and electrically separated between the first string select region R2a and the second string select region R2b and the extension region R2.

The stack structures GS1, GS2, GS3 and GS4 may include a plurality of vertically stack structures GS1 to GS4. In FIGS. 4A and 4C, the semiconductor device is illustrated as including the first to fourth stack structures GS1, GS2, GS3 and GS4, but various example embodiments are not thereto, but the semiconductor device may include five to eight stages of stack structures GS1 to GSn. However, according to some example embodiments, the stack structures GS1 may be formed of a single stack structure.

The gate electrodes 130 may include at least one lower gate electrode 130L included in a gate of the ground selection transistor, memory gate electrodes 130M included in a plurality of memory cells, and upper gate electrodes 130U as the string select line included in gates of the string select transistors. Here, lower gate electrode 130L and the upper gate electrodes 130U may be referred to as "lower" and "upper" based on a direction during a manufacturing process. The number of memory gate electrodes 130M included in the memory cells may be determined according to the capacity of the semiconductor device 100. According to an example embodiment, the number of upper and lower gate electrodes 130U and 130L may be one to two or more, respectively, and the upper and lower gate electrodes 130U and 130L may have a structure identical to or different from that of the memory gate electrodes 130M. In some example embodiments, the number of upper gate electrodes 130U may be illustrated as being three. Erase gate electrodes may be further disposed below the upper gate electrodes 130U. Additionally, portions of the gate electrodes 130, for example, memory gate electrodes 130M adjacent to the upper or lower gate electrodes 130U and 130L, may be dummy gate electrodes, but example embodiments are not limited thereto.

Referring to FIGS. 2 and 3, the gate electrodes 130 may be disposed to be separated from each other in a Y-direction, by separation region MS extending continuously from the first memory region R1a through the extension region R2 in the second memory region R1b. The gate electrodes 130 between a pair of separation regions MS may be included in one memory block BLK, but the scope of the memory block BLK is not limited thereto. Portions of the gate electrodes 130, for example, the memory gate electrodes 130M, may be respectively included in a single layer in one memory block BLK.

The gate electrodes 130 may be stacked and spaced apart from others thereof vertically in the first memory region R1a, the first string select region R2a, the extension region R2, the second string select region R2b, and the second memory region R1b, and may maintain a continuous plate shape without forming a staircase-shaped step structure even in the extension region R2. The contact region of each gate electrode 130 may be defined as a region in contact with the contact plugs MC1a, MC1b and MC2 in the first string select region R2a, the second string select region R2b and the extension region R2.

The gate electrodes 130 may be formed of, for example, W, Ru, Mo, Nb, Ni, Co, Ti, Ta, TiN, TaN, WN, NbN, TiAl, TiAlN, TiSi, TiSiN, TaSi, TaSiN, RuTiN, NiSi, CoSi or combinations thereof, but example embodiments are not limited thereto. According to some example embodiments, the gate electrodes 130 may further include a diffusion barrier layer 131, and the diffusion barrier layer 131 may include, for example, tungsten nitride (WN), tantalum nitride (TaN), titanium nitride (TiN), or combinations thereof.

The interlayer insulating layers 120 may be disposed between the gate electrodes 130 to form the stack structure GS1, GS2, GS3 and GS4. Similarly to the gate electrodes 130, the interlayer insulating layers 120 may be spaced apart from each other in a direction, perpendicular to the upper surface of the conductive layer 101, and may be disposed to extend in the X-direction. The interlayer insulating layers 120 may include an insulating material such as silicon oxide or silicon nitride.

In some example embodiments, thicknesses of the interlayer insulating layers 120 may not all be the same. For example, an uppermost interlayer insulating layer 121, among the interlayer insulating layers 120, may have a thickness greater than thicknesses of the other interlayer insulating layers 120, but example embodiments are not limited thereto.

The separation regions MS may be disposed to extend in the X-direction by penetrating through at least a portion of the gate electrodes 130. The separation regions MS may extend in the X-direction by sequentially crossing the first memory region R1a, the first string select region R2a, the extension region R2, the second string select region R2b, and the second memory region R1b. The separation regions MS may be parallel to each other. The separation regions MS may penetrate through all of the stacked gate electrodes 130 and may thus be connected to the conductive layer 101. The separation regions MS may extend as one region in the X-direction, but may be partially extend intermittently or may be disposed only in certain regions. The separation regions MS may have a line shape on an X-Y plane, but alternatively, may have a shape in which a side surface thereof has a continuous curved surface and extends in the X-direction.

A separation insulating layer 164 may be disposed in the separation regions MS. Due to the high aspect ratio, the separation insulating layer 164 may have a shape which a width thereof decreases toward the conductive layer 101, but example embodiments are not limited thereto. An upper surface of the separation insulating layer 164 may be in contact with an upper insulating layer 150, and a lower surface thereof may be in contact with the upper surface of the conductive layer 101.

The insulating regions SS may include first insulating regions SS1a and SS1b extending in the X-direction, and second insulating regions SS2a and SS2b extending in the Y-direction, between the separation regions MS adjacent to each other. The insulating regions SS may selectively penetrate through only the upper gate electrodes 130U1 to 130U3, i.e., the string select lines SSL, and may separate the upper gate electrodes 130U1 to 130U3 of the stack structure GS1 to GS4 into a plurality of sub-sections RS0 to RS8.

Referring to FIG. 3, the second insulating regions SS2a and SS2b may cross the extension region R2 and the first and second string select regions R2a and R2b in the Y-direction to separate the upper gate electrodes 130U1 to 130U3. The second insulating regions SS2a and SS2b may be disposed between the extension region R2 and the first string select region R2a and between the extension region R2 and the second string select region R2b, respectively. When at least three upper gate electrodes 130U1 to 130U3 are allocated to the string select line, the three upper gate electrodes 130U1 to 130U3 may be simultaneously penetrated by the second insulating regions SS2a and SS2b, and may thus be separated into the plurality of sub-section RS0 to RS8 physically/electrically spaced apart from each other on the plane. To this end, the second insulating regions SS2a and SS2b may be formed of an insulating material (cf. insulating layer 168).

The first insulating regions SS1a and SS1b may include first horizontal insulating regions SS1a extending across the first memory region R1a and the first string select region R2a in the X-direction, and second horizontal insulating regions SS1b extending across the second memory region R1b and the second string select region R2b, respectively. The first horizontal insulating regions SS1a and the second horizontal insulating regions SS1b may be disposed in plural between the separation regions MS, and only the upper gate electrodes 130U1 to 130U3 like the second insulating regions SS2a and SS2b may be selectively separated.

The first insulating regions SS1a and SS1b and the second insulating regions SS2a and SS2b may be disposed to have the same length in the X-direction from the upper portion, and lower surfaces thereof may be disposed on a lower level than that of a lower surface of a lowermost upper gate electrode 130U1, among the upper gate electrodes 130U1 to 130U3, and may be disposed on a level higher than that of a lower surface of the interlayer insulating layer 120 below the lowermost upper gate electrode 130U1. Accordingly, the first insulating regions SS1a and SS1b and the second insulating regions SS2a and SS2b may completely penetrate through all of the upper gate electrodes 130U1 to 130U3, so that the upper gate electrodes 130U1 to 130U3 may be included in the plurality of sub-sections RS0 to RS8 completely physically/electrically spaced apart from each other, as illustrated in FIG. 3. In FIG. 3, the sub-region RS0 in the extension region R2 and the upper gate electrodes 130U1 to 130U3 of each memory region and the string select regions R1a and R2a/R1b and R2b are illustrated as being separated into four sub-regions RS1 to RS4/RS5 to RS8, respectively, but example embodiments are not limited thereto.

The insulating regions SS1a, SS1b, SS2a and SS2b may be not disposed in the extension region R2, but may separate the extension region R2 from the string select regions R2a and R2b, and may separate the string select regions R2a and R2b into the plurality of sub-sections RS1 to RS8, and accordingly, as illustrated in FIG. 3, the upper gate electrodes 130U1 to 130U3 may not be separated in the extension region R2 and may form one plate-shaped sub-section RSO. In this case, the insulating regions SS1a, SS1b, SS2a and SS2b may selectively penetrate through only the upper gate electrodes 130U1 to 130U3, and may not extend on a level equal to or less than the memory gate electrode 130M, so that the memory gate electrodes 130M and the lower gate electrodes 130L may not be separated by the insulating regions SS1a, SS1b, SS2a and SS2b, and the first memory region R1a, the first string select region R2a, the extension region R2, the second string select region R2b and the second memory region R1b all may be stacked to have a single plate shape.

One end of the first insulating regions SS1a and SS1b may extend into the extension region R2 by crossing the second insulating regions SS2a and SS2b, but example embodiments are not limited thereto, and the first insulating regions SS1a and SS1b may be connected to the second insulating regions SS2a and SS2b.

The first insulating regions SS1a and SS1b may be disposed by crossing portions of the channel structures CHa and CHb in the first and second memory regions R1a and R1b. The first insulating regions SS1a and SS1b may have a certain width in the Y- direction, and may extend by crossing the X-direction between the plurality of channel structures CHa and CHb arranged to form a zigzag matrix. Accordingly, when the plurality of channel structures CHa and CHb are arranged to have the same separation distance, the first insulating regions SS1a and SS1b may extend by simultaneously crossing one column of channel structures CHa and CHb. The first insulating regions SS1a and SS1b may be recessed in upper ends of the channel structures CHa and CHb, for example, portions of the channel structures CHa and CHb facing three upper gate electrodes 130U, so that portions of the channel structures Cha and CHb may be removed. In this case, the channel structures CHa and CHb may be recessed by a length smaller than radii of the channel structures CHa and CHb from a channel center axis to an internal wall of a channel hole. Accordingly, the first insulating regions SS1a and SS1b may be disposed so that 1/2 or more of the channel structures CHa and CHb remain on an upper surface thereof, without passing through the channel center axis of the channel structures CHa and CHb, but example embodiments are not limited thereto. The channel structures CHa and CHb in which the first insulating regions SS1a and SS1b are recessed may be effective channel structures that actually function as the memory cells, rather than dummy channel structures. Each of the insulating regions SS1a, SS1b, SS2a and SS2b may include an upper separation insulating layer 168. The upper separation insulating layer 168 may include an insulating material, and may include, for example, silicon oxide, silicon nitride, or silicon oxynitride.

The channel structures CHa and CHb may be spaced apart from each other while forming rows and columns on the conductive layer 101 of the first memory region R1a and the second memory region R1b. Each of the channel structures CHa and CHb may include first channel structures CHa and second channel structures CHb respectively disposed in the first memory region R1a and the second memory region R1b, and arrangements of the first channel structures CHa and the second channel structures CHb may be identical or mirror-image. In each of the first memory region R1a and the second memory region R1b, the first channel structures CHa and the second channel structures CHb may be arranged to have a zigzag shape in one direction in the X-Y plane. The first channel structures CHa and the second channel structures CHb may penetrate through the gate electrodes 130, may extend in a vertical direction, perpendicular to the upper surface of the conductive layer 101, for example, in the Z-direction, may have a pillar shape, and may have an inclined side surface in which a width thereof becomes narrower as a distance from the conductive layer 101 decreases depending on the aspect ratio.

Each of the first channel structures CHa and the second channel structures CHb may have a form of connecting first to fourth channel portions respectively penetrating through the first to fourth stack structures GS1 to GS4 of the gate electrodes 130, and may have a bent portion due to a difference or a change in width in the extension region R2.

As illustrated in an enlarged view of FIG. 5A, each of the first channel structures CHa and the second channel structures CHb may include a first portion in the stack structures GS1 to GS4, and a second portion protruding below the stack structures GS1 to GS4 and in contact with the conductive layer 101.

A channel layer 140 may be entirely disposed in the first portion and the second portion of the first and second channel structures CHa and CHb, and may be disposed up to an upper end of the second portion. The channel layer 140 may include a protrusion portion protruding and exposed below the stack structures GS1 to GS4 and disposed in the second portion of the first and second channel structures CHa and CHb, and a non-protrusion portion disposed in the first portion of the channel structures CHa and CHb. Protruding lengths of the second portions of the first and second channel structures CHa and CHb and the protrusion portions of the channel layer 140 may not be the same, but example embodiments are not limited thereto. The channel layer 140 may be formed to have an annular shape in which a side surface thereof surrounds an internal buried insulating layer 147, but according to an example embodiment, the channel layer 140 may have a pillar shape such as a cylinder or a prism without the buried insulating layer 147. The protrusion portion of the channel layer 140 may extend into the conductive layer 101 and directly contact the conductive layer 101. The protrusion portion may be formed to have a gentle slope to the non-protrusion portion so that the annular shape is maintained as illustrated in FIG. 5A. The channel layer 140 may include a semiconductor material such as polycrystalline silicon or single crystalline silicon, and the semiconductor material may be an undoped material or a material containing P-type or N-type impurities. However, example embodiments are not limited thereto.

Channel pads 149 may be disposed on an upper surface of the channel layer 140 in the first and second channel structures CHa and CHb. The channel pads 149 may be disposed to cover an upper surface of the buried insulating layer 147 and may be electrically connected to the channel layer 140. The channel pads 149 may include, for example, doped polycrystalline silicon. However, example embodiments are not limited thereto.

The channel dielectric layer 145 may be disposed between the gate electrodes 130 and the channel layer 140. The channel dielectric layer 145 may include a tunneling layer 141, a charge storage layer 142, and a blocking layer 143 sequentially stacked from the channel layer 140. The tunneling layer 141 may tunnel charges into the charge storage layer 142, and may include, for example, silicon oxide (SiO₂), silicon nitride (Si₃N₄), silicon oxynitride (SiON), or combinations thereof. However, example embodiments are not limited thereto. The charge storage layer 142 may be a charge trapping layer or a floating gate conductive layer. The blocking layer 143 may include silicon oxide (SiO₂), silicon nitride (Si₃N₄), silicon oxynitride (SiON), a high-κ dielectric material, or combinations thereof. However, example embodiments are not limited thereto. According to some example embodiments, at least a portion of the channel dielectric layer 145 may be included in a channel dielectric layer extending in a horizontal direction along the gate electrodes 130.

The channel dielectric layer 145 may be removed below the stack structures GS1 to GS4 so that the protrusion portion of the channel layer 140 in the second portion is exposed to the outside. Accordingly, a lower end of the channel dielectric layer 145 may be in contact with the conductive layer 101, and a side surface of the channel dielectric layer 145 may surround the non-protrusion portion of the channel layer 140 in the first portion.

The channel layer 140, the channel dielectric layer 145, and the buried insulating layer 147 may be connected to each other between the first to fourth channel portions.

The support structures DH may be disposed in the first string select region R2a, the extension region R2, and the second string select region R2b, and may have a structure identical to or similar to the channel structures CHa and CHb, but may not perform any actual function in the semiconductor device 100. The support structures DH may be regularly arranged to form columns and rows in the first string select region R2a, the extension region R2, and the second string select region R2b. The support structures DH may have a diameter equal to or greater than a maximum diameter of the channel structures CHa and CHb, and may have a diameter equal to or smaller than a maximum diameter of the contact plugs MC1a, MC1b and MC2. The shape, number and/or gap of the support structures DH may vary. The channel structures CHa and CHb and the support structures DH may have a circular shape or a shape close to the circular shape, but example embodiments are not limited thereto and the channel structures CHa and CHb may have an oval shape. The support structures DH may include a vertical portion penetrating through the stack structures GS1 to GS4, like the channel structures CHa and CHb, and extending in the Y-direction, and horizontal portions protruding from the vertical portion toward each of the gate electrodes 130, but the shape of the support structures DH is not limited thereto. The support structures DH may be supporters that may reduce or prevent deformation such as warpage of the stack structures GS1 to GS4.

The first semiconductor structure S1 may include a first string select region R2a, an extension region R2, and contact plugs MC1a, MC1b and MC2 respectively connected to the gate electrodes 130 in the second string select region R2b. The contact plugs MC1a, MC1b and MC2 may penetrate through at least a portion of the uppermost interlayer insulating layer 121, and may extend downwardly in the Z-direction and may be connected to upper surfaces of allocated gate electrodes 130. The contact plugs MC1a, MC1b and MC2 have a circular shape or an oval shape on the X-Y plane, as illustrated in FIGS. 2 and 3, and may be spaced apart from each other in the X-direction and the Y-direction. The contact plugs MC1a, MC1b and MC2 may be arranged to have a grid form or a zigzag form.

Each of the contact plugs MC1a, MC1b and MC2 may include a plug conductive layer 175, and a side insulating layer 160 may be further disposed on a side surface of the plug conductive layer 175. In each of the contact plugs MC1a, MC1b and MC2, the plug conductive layer 175 may be contact with and connected to the contact region of one of the gate electrodes 130, and the side insulating layer 160 may electrically insulate the plug conductive layer 175 from the gate electrodes 130 adjacent to the side surface of the plug conductive layer 175. The plug conductive layer 175 may continuously extend from lower surfaces of the contact plugs MC1a, MC1b and MC2 in contact with the contact region of the gate electrode 130 to upper surfaces of the contact plugs MC1a, MC1b and MC2.

In some example embodiments, eight gate electrodes 130 of each of the stack structures GS1 to GS4 may be allocated, and at least one contact plug MC1a, MC1b and MC2 in physical/electrical contact with each of the gate electrodes 130 may be disposed. The number of gate electrodes 130 in the first to fourth stack structures GS1-GS4 is an example, but example embodiments are not limited thereto.

The contact plugs MC1a, MC1b and MC2 may include string contact plugs MC1a and MC1b and word line contact plugs MC2.

The string contact plugs MC1a and MC1b may be disposed in the first string contact region R2a and the second string contact region R2b, and may be connected to a desired (and/or alternatively predetermined) number of upper gate electrodes 130U1 to 130U3 functioning as string select lines, among the upper gate electrodes 130U1 to 130U3, respectively.

FIGS. 1 to 5B are illustrated as including three string select lines, and thus, if explained accordingly, three string select contact plugs MC1a and MC1b connected to the upper gate electrodes 130U1 to 130U3, which are respective string select lines, may be disposed in each of sub-sections RS1 to RS8. That is, the string select contact plugs MC1a and MC1b connected to each of the string select lines may be disposed in the sub-regions RS1 to RS8 of the upper gate electrodes 130U separated by the first and second insulating regions SS1a, SS1b, SS2a and SS2b. In some example embodiments, each of the upper gate electrodes 130U1 to 130U3 is illustrated as being connected to one string select contact plug MC1a or MC1b, but differently therefrom, a plurality of string select contact plugs MC1a and MC1b may be connected to one upper gate electrode 130U1 to 130U3. Accordingly, the number of string select contact plugs MC1a and MC1b allocated to each of the sub-sections RS1 to RS8 is the same, and the number of string select contact plugs MC1a and MC1b allocated to each of the sub-regions RS1 to RS8 may satisfy an integer multiple of the number of gate electrodes functioning as string select lines.

In each of the sub-regions RS1 to RS8, the first to third upper gate electrodes 130U1 to 130U3 may be individually connected by the three string select contact plugs MC1a and MC1b, thus transmitting an electrical signal to select the channel structures CHa and CHb of the corresponding sub-zones RS1 to RS8.

The string select contact plugs MC1a and MC1b do not protrude outside the sub-regions RS1 to RS8 of the first to third upper gate electrodes 130U1 to 130U3, lower ends of first string select contact plugs MC1a and MC1b may be in direct contact with an upper surface of an uppermost upper gate electrode 130U3, lower ends of second string select contact plugs MC1a and MC1b may be in direct contact with an upper surface of a next uppermost upper gate electrode 130U2, and lower ends of third string select contact plugs MC1a and MC1b may be in direct contact with an upper surface of a third upper gate electrode 130U1, which is a lower end of the next uppermost upper gate electrode 130U2. Accordingly, the string select contact plugs MC1a and MC1b does not extend outside of each of the sub-regions RS1 to RS8 formed by cutting the three first to third upper gate electrodes 130U1 to 130U3, that is, below the third upper gate electrode 130U1. Arrangements of the string select contact plugs MC1a and MC1b in each of sub-regions RS1 to RS8 may be substantially the same.

In the extension region R2, when the word line contact plugs MC2 respectively connected to the memory gate electrodes 130M and the lower gate electrodes 130L are allocated one by one, the word line contact plugs MC2 may be arranged to have different lengths to be connected to the gate electrodes 130M and 130L on different levels.

In some example embodiments relating to FIGS. 2 to 5B, first to fourth stack structures GS1 to GS4 are illustrated as respectively including eight layers of gate electrodes 130, and three gate electrodes 130U in an upper portion may function as string select lines, the remaining 29 gate electrodes 130M and 130L may remain. However, example embodiments are not limited thereto. Word line contact plugs MC2 in which lengths are adjusted to contact upper surfaces of the 29 gate electrodes 130M and 130L, respectively, may be disposed in the extension region R2.

The word line contact plugs MC2 may be arranged in various manners, and in some example embodiments, it is illustrated that as the word line contact plugs MC2 move in the Y-direction in one row, the word line contact plugs MC2 may be lowered by one layer in the Z-direction and to contact the gate electrodes 130. Accordingly, as illustrated in FIG. 4C, lengths of the word line contact plugs MC2 in the Z-direction may increase so that the word line contact plugs MC2 arranged in the Y-direction are in contact with a fourth gate electrode 130 to a seventh gate electrode 130, respectively. In a second row, the word line contact plugs MC2 may extend again to contact an eighth gate electrode 130 to an eleventh gate electrode 130, respectively, and in this manner, the word line contact plugs MC2 may be arranged to have a longer length toward the second memory region R1b in the X-direction, and the word line contact plugs MC2 may be arranged to have a longer length as they move downwardly in the Y-direction, but example embodiments are not limited thereto. As an example, the word line contact plugs MC2 may be arranged in one column, and may also be arranged symmetrically so that the length thereof becomes longer toward a center.

In each of the contact plugs MC1a, MC1b and MC2, the side insulating layer 160 may be disposed only on a side surface of the plug conductive layer 175 so that the lower gate electrode 130 is in direct contact with a lower surface of the plug conductive layer 175, and according to an example embodiment, some of the plug conductive layers 175 may be disposed to extend by a lower level than that of an upper surface of an allocated gate electrode 130, but does not extend by a lower level than that of a lower surface of the allocated gate electrode 130. Accordingly, the lower surface of the plug conductive layer 175 may be equal to or lower than the upper surface of the gate electrode 130 in contact therewith, and may be disposed on a level higher than that of the lower surface thereof.

Additionally, as illustrated in FIG. 5B, each of the contact plugs MC1a, MC1b and MC2 may further include a contact barrier layer 172 covering portions of an upper surface, a side surface, and a bottom surface of the plug conductive layer 175.

The plug conductive layer 175 of the contact plugs MC1a, MC1b and MC2 may include a conductive material, and may include, for example, at least one of tungsten (W), copper (Cu), aluminum (Al), and alloys thereof. However, example embodiments are not limited thereto. For example, the plug conductive layer 175 may include tungsten (W). The contact barrier layer 172 may include tungsten nitride (WN), tantalum nitride (TaN), titanium nitride (TiN), or combinations thereof.

The side insulating layers 160 may include an insulating material, and may include, for example, silicon oxide, silicon nitride, or silicon oxynitride. However, example embodiments are not limited thereto.

The contact plugs MC1a, MC1b and MC2 may all have the same structure, but only lengths thereof may be different from each other, and the contact plugs MC1a, MC1b and MC2 may have a structure in which widths thereof gradually decrease toward the conductive layer 101, and a maximum width of the contact plugs MC1a, MC1b and MC2 may be greater than a maximum width of the channel structures CHa and CHb, and may be equal to or greater than a maximum width of the support structure DH. The contact plugs MC1a, MC1b and MC2 may have a bent portion BP in which a side surface thereof is bent according to the level of the gate electrode 130 in contact therewith. In this case, the contact plugs MC1a, MC1b and MC2 having a plurality of bent portions BP may be included depending on the number of stages, but example embodiments are not limited thereto. For example, as illustrated in FIG. 5B, third string select contact plugs MC1a and MC1b, among the string select contact plugs MC1a and MC1b, may include a bent portion BP in a region in contact with an upper surface of a second gate electrode 130U2 from the upper portion, and a width thereof decreases along the bent portion BP and may gradually decrease toward the conductive layer 101.

In the first string select region R2a, the extension region R2, and the second string select region R2b, the support structures DH may be arranged to have a regular pattern around the contact plugs MC1a, MC1b and MC2. For example, as illustrated in FIG. 2, the support structures DH, and the contact plugs MC1a, MC1b, and MC2 may be arranged alternately, but example embodiments are not limited thereto.

The cell region insulating layer 150 may be disposed to cover the gate structures GS1 to GS4. The cell region insulating layer 150 may include a plurality of insulating layers according to some example embodiments. The cell region insulating layer 150 may be formed of an insulating material, and may include, for example, at least one of silicon oxide, silicon nitride, and silicon oxynitride. However, example embodiments are not limited thereto.

The studs 185 and the cell interconnection lines 180 may be included in a cell interconnection structure electrically connected to the memory cells. The studs 185 may penetrate through a portion of the cell region insulating layer 150 and may be connected to the channel structures CHa and CHb and the contact plugs MC1a, MC1b and MC2, and may be electrically connected to the channel layers 140 and the gate electrodes 130. The studs 185 may have a plug shape, and the cell interconnection lines 180 may have a line shape, but example embodiments are not limited thereto. The studs 185 and the cell interconnection lines 180 may include a metal, and may include, for example, tungsten (W), copper (Cu), and aluminum (Al). However, example embodiments are not limited thereto.

An upper insulating layer 190 may be further disposed on the cell region insulating layer 150 to cover the cell interconnection lines 180. The upper insulating layer 190 may be formed of an insulating material, and may include, for example, at least one of SiO, SiN, SiCN, SiOC, SiON, and SiOCN. However, example embodiments are not limited thereto. An upper portion of the upper insulating layer 190 may function as a first bonding insulating layer.

The first bonding vias 195, the first bonding metal layers 198, and the first bonding insulating layer may be included in the first bonding structure of the first semiconductor structure S1. The first bonding vias 195 may be disposed on the cell interconnection lines 180, and the first bonding metal layers 198 may be connected to the first bonding vias 195. Upper surfaces of the first bonding metal layers 198 may be exposed to an upper surface of the first semiconductor structure S1. The first bonding metal layers 198 may be bonded and connected to the second bonding metal layers 298 of the second semiconductor structure S2. The first bonding vias 195 and the first bonding metal layers 198 may include a conductive material, for example, copper (Cu). The first bonding insulating layer may form dielectric-to-dielectric bonding with a second bonding insulating layer of the second semiconductor structure S2.

Meanwhile, the second semiconductor structure S2 may include a substrate 201, source/drain regions 205 and device isolating layers 210 in the substrate 201, circuit elements 220 disposed on the substrate 201, a peripheral region insulating layer 290, circuit contact plugs 270, circuit interconnection lines 280, second bonding vias 295, and second bonding metal layers 298.

The substrate 201 may have a lower surface extending in the X-direction and the Y-direction. An active region may be defined on the substrate 201 by the device isolating layers 210. The source/drain regions 205 including impurities may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include planar transistors. Each of the circuit element 220 may include a circuit gate dielectric layer 222, a spacer layer 224, and a circuit gate electrode 225. The source/drain regions 205 may be disposed as source/drain regions in the substrate 201 on both sides of the circuit gate electrode 225.

The peripheral region insulating layer 290 may be disposed to cover the circuit elements 220 on a lower surface of the substrate 201. The peripheral region insulating layer 290 may include a plurality of insulating layers formed in different process operations. The peripheral region insulating layer 290 may be formed of an insulating material. A portion of the peripheral region insulating layer 290 may function as a second bonding insulating layer.

The circuit contact plugs 270 and the circuit interconnection lines 280 may be included in a circuit interconnection structure electrically connected to the circuit elements 220 and the source/drain regions 205. The circuit contact plugs 270 may have a cylindrical shape, and the circuit interconnection lines 280 may have a line shape. An electrical signal may be applied to the circuit element 220 through the circuit contact plugs 270 and the circuit interconnection lines 280. In a region not illustrated, the circuit contact plugs 270 may also be connected to the circuit gate electrode 225. The circuit interconnection lines 280 may be connected to the circuit contact plugs 270 and may be arranged to have a plurality of layers. The circuit contact plugs 270 and the circuit interconnection lines 280 may include a conductive material, and may include, for example, tungsten (W), copper (Cu), and aluminum (Al), and each of the components may further include a diffusion barrier layer. However, example embodiments are not limited thereto. In some example embodiments, the number of layers of the circuit contact plugs 270 and the circuit interconnection lines 280 may be variously changed.

The second bonding vias 295, the second bonding metal layers 298, and the second bonding insulating layer may be included in a second bonding structure, and may be disposed below portions of the circuit interconnection lines 280 in a lowermost portion. The second bonding vias 295 may have a cylindrical shape, and the second bonding metal layers 298 may have a pad shape having a circular shape on a plane or a relatively short line shape. Lower surfaces of the second bonding metal layers 298 may be exposed to a lower surface of the second substrate structure S2. The second bonding vias 295 and the second bonding metal layers 298 may provide an electrical connection path with the first semiconductor structure S1. In some example embodiments, portions of the second bonding metal layers 298 may not be connected to the circuit interconnection lines 280 and may be disposed only for bonding. The second bonding vias 295 and the second bonding metal layers 298 may include a conductive material, for example, copper (Cu).

The second bonding insulating layer may be defined as a desired (and/or alternatively predetermined) thickness from a lower surface of the peripheral region insulating layer 290, but may be implemented as an additional insulating layer on the lower surface of the peripheral region insulating layer 290. The second bonding insulating layer may be a layer for dielectric-to-dielectric bonding with the first bonding insulating layer of the first semiconductor structure S1. The second bonding insulating layer may also function as a diffusion barrier layer of the second bonding metal layers 298, and may include, for example, at least one of SiO, SiN, SiCN, SiOC, SiON, and SiOCN. However, example embodiments are not limited thereto.

The first and second semiconductor structures S1 and S2 may be bonded to each other by bonding the first bonding metal layers 198 and the second bonding metal layers 298 and by bonding the first bonding insulating layer and the second bonding insulating layer. The bonding of the first bonding metal layers 198 and the second bonding metal layers 298 may be, for example, copper (Cu)-to-copper (Cu) bonding, and the bonding of the first bonding insulating layer and the second bonding insulating layer may be, for example, dielectric-to-dielectric bonding such as SiCN-SiCN bonding. The first and second semiconductor structures S1 and S2 may be bonded to each other by hybrid bonding including copper (Cu)-to-copper (Cu) bonding and dielectric-to-dielectric bonding.

The first and second semiconductor structures S1 and S2 may be packaged in a form in which the first semiconductor structure S1 is disposed below the second semiconductor structure S2, as illustrated in FIGS. 4A to 4C, or alternatively, the first and second semiconductor structures S1 and S2 may be packaged upside down in a form in which the second semiconductor structure S2 is disposed below the first semiconductor structure S1.

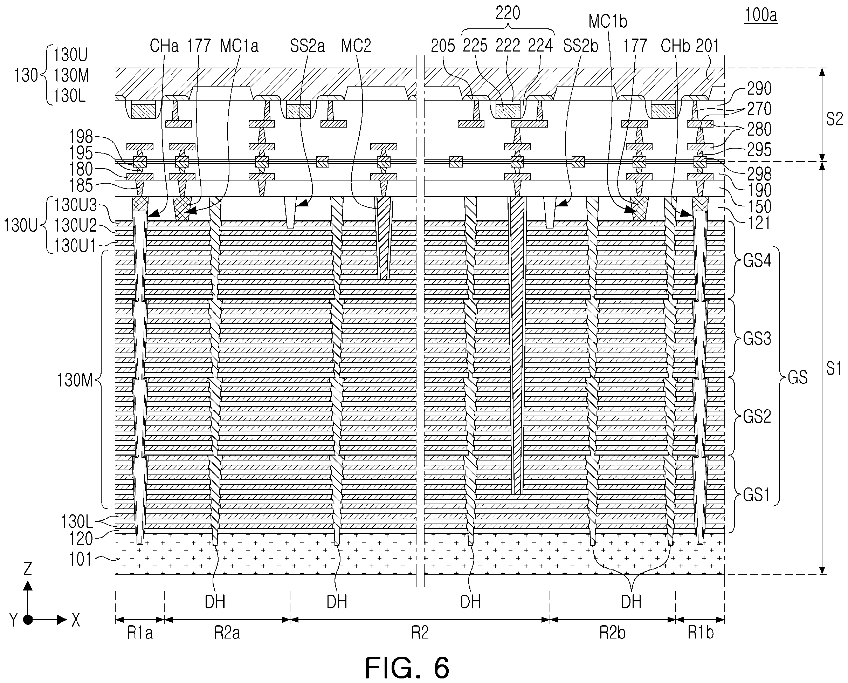

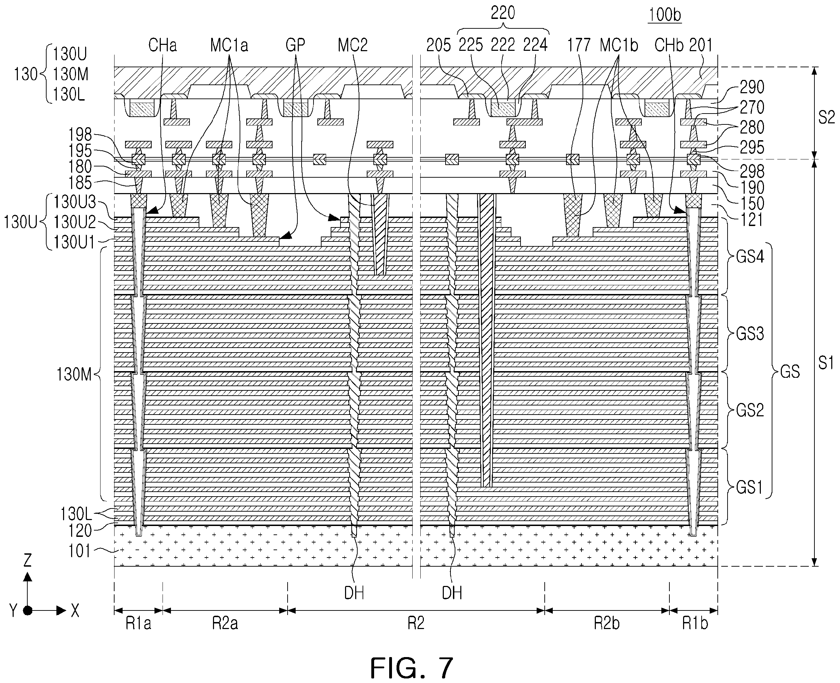

FIGS. 6 and 7 are schematic cross-sectional views of a semiconductor device according to some example embodiments.

Referring to FIG. 6, in a semiconductor device 100a, an uppermost gate electrode 130U3, among upper gate electrodes 130U, may function as a string select line. Accordingly, the first and second insulating regions SS1a, SS1b, SS2a and SS2b may extend by a level lower than a level of an uppermost gate electrode 130U3 so as to separate a portion up to the uppermost gate electrode 130U3.

The first and second string select contact plugs MC1a and MC1b may include only a plug-shaped conductive layer 177, unlike the string select contact plug of FIGS. 2 to 5B.

That is, only the conductive layer 177 may be disposed in the form of a plug without an additional side insulating layer, and may be disposed to contact an upper surface of the uppermost gate electrode 130U3 in first and second string select regions R2a and R2b, respectively.

Accordingly, word line contact plugs MC2 may be disposed to contact the gate electrode 130 on a lower level than a level of the uppermost gate electrode 130U3, respectively, and the shape of the word line contact plugs MC2 may be the same as the shape of FIG. 5B including the plug conductive layer 170 and the side insulating layer 160. In this manner, the shapes of the first and second string select contact plugs MC1a and MC1b and the word line contact plugs MC2 may be different from each other.

Referring to FIG. 7, a semiconductor device 100b is identical to the semiconductor device of FIGS. 2 to 5B except for the structures of the string select contact plugs MC1a and MC1b and the upper gate electrodes 130U of the string select line. In the semiconductor device 100b, the first and second string select contact plugs MC1a and MC1b and the word line contact plugs MC2 may have different shapes.

The upper gate electrodes 130U may include contact regions for contacting the first and second string select contact plugs MC1a and MC1b in the first string select region R2a and the second string select region R2b, and may include a staircase-shaped step structure GP so that the corresponding contact regions are exposed to the outside.

When three upper gate electrodes 130U1 to 130U3 are allocated to the string select line, the three upper gate electrodes 130U1 to 130U3 may have a staircase-shaped step structure GP in which a length thereof increases as the upper gate electrodes 130U1 to 130U3 move downwardly. Accordingly, a staircase-shaped dummy step structure GP may be formed in an extension region R2 on an opposite side thereof, but a staircase width of the dummy step structure GP of the extension region R2 may be different from a staircase width of the step structure GP of the first and second string select regions R2a and R2b. For example, the staircase width of the dummy step structure GP in the extension region R2 may be narrower than the staircase width of the step structure GP in the first and second string select regions R2a and R2b, but example embodiments are not limited thereto.

The string select contact plugs MC1a and MC1b may be disposed to respectively contact the contact regions of each of the string select lines exposed according to the staircase-shaped step structure GP.

The string select contact plugs MC1a and MC1b may be identically formed using only the conductive layer 177. That is, only the conductive layer 177 may be disposed to have a plug shape without an additional side insulating layer, so that the conductive layer 177 may be in contact with upper surfaces of exposed contact regions of the upper gate electrodes 130U, respectively. Accordingly, the string select contact plugs MC1a and MC1b in respective sub-sections RS1 to RS8 may have different lengths.

In the extension region R2, the word line contact plugs MC2 may be disposed to contact gate electrodes 130M and 130L on levels lower than levels of the upper gate electrodes 130U1 to 130U3, respectively, and a shape of the word line contact plugs MC2 may be the same as the shape of FIG. 5B including the plug conductive layer 175 and the side insulating layer 160.

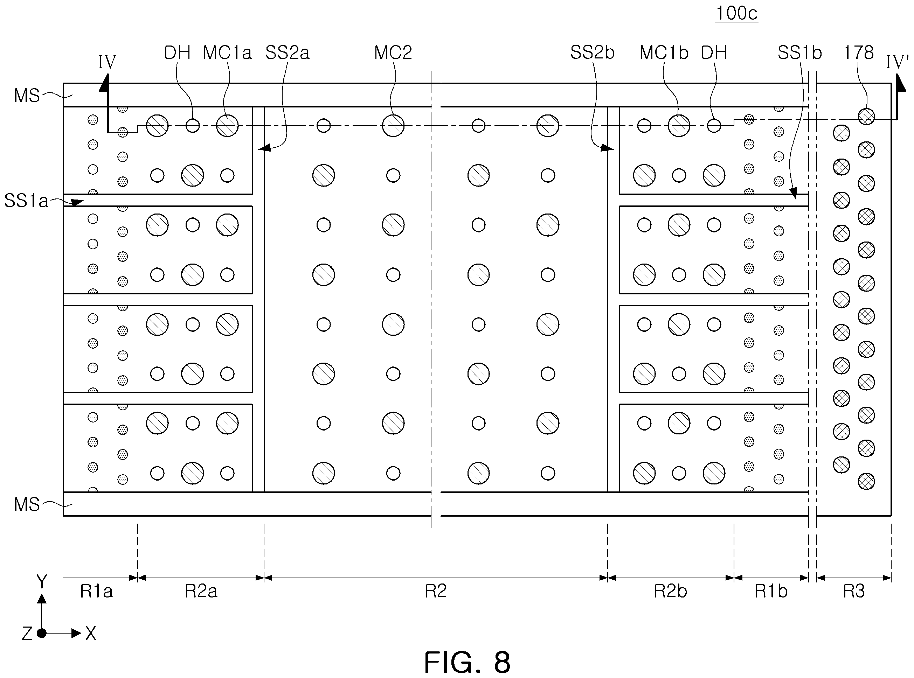

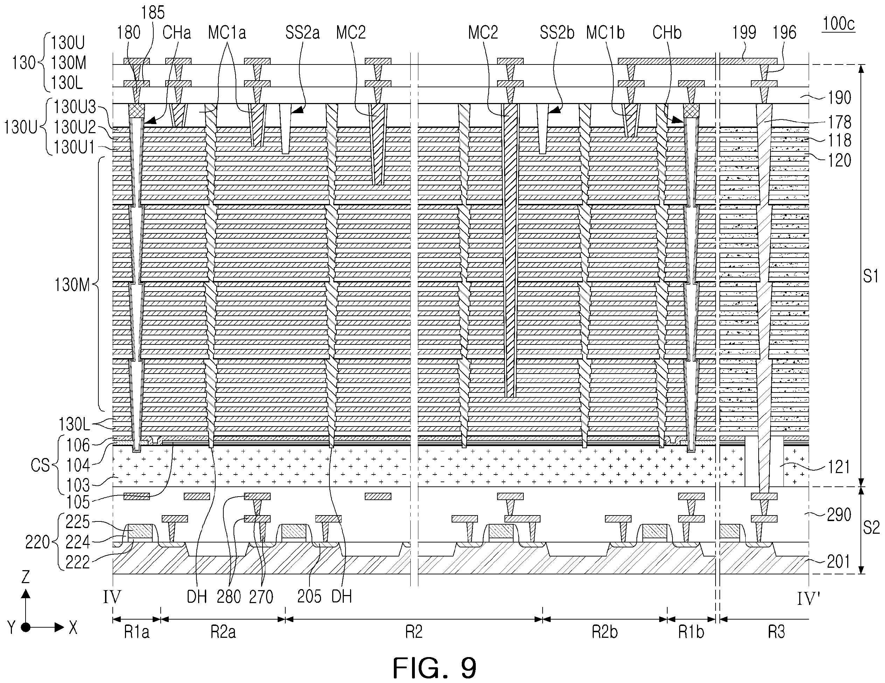

FIG. 8 is a schematic plan view of a semiconductor device according to some example embodiments, and FIG. 9 is a schematic cross-sectional view of a semiconductor device according to some example embodiments and is a cross-sectional view taken along cutting line cutting line IV-IV' of the semiconductor device of FIG. 8.

Referring to FIGS. 8 and 9, a second semiconductor structure S2 of a semiconductor device 100c may be disposed below a first semiconductor structure S1. The first semiconductor structure S1 may further include an edge region R3, and may further include a through-via 178, first and second horizontal conductive layers 104 and 106, a horizontal insulating layer 105, and a substrate insulating layer 121, which are disposed in the edge region R3. In the semiconductor device 100c, the first semiconductor structure S1 may be formed on the second semiconductor structure S2 rather than being bonded to the second semiconductor structure S2. Accordingly, the first and second semiconductor structures S1 and S2 may not include the bonding structures described above.

The edge region R3 may be a region in which the gate electrodes 130 do not extend. In the edge region R3, sacrificial insulating layers 118 may be alternately stacked with interlayer insulating layers 120 on a plate layer 103. Alternatively, a separate capping layer may be disposed therein, but example embodiments are not limited thereto. The through-vias 178 may extend into the second semiconductor structure S2 by penetrating through the sacrificial insulating layers 118 and the interlayer insulating layers 120.

The through-vias 178 may electrically connect an upper interconnection line 199 and a circuit interconnection line 280.

Specifically, upper studs 196 in contact with a cell interconnection line 180 connected to contact plugs MC1a, MC1b and MC2 may be further included in an upper insulating layer 190, and an upper interconnection line 199 connected to the upper studs may be further included therein. The upper interconnection line 199 is connected to each of the contact plugs MC1a, MC1b and MC2, and may be connected to the through-vias 178, respectively, thus electrically connecting the second semiconductor structure S2 and each of the contact plugs MC1a, MC1b and MC2.

The through-vias 178 may be electrically separated from the plate layer 103 by a substrate insulating layer 121. The through-via 178 may have bent portions corresponding to bent portions of channel structures CHa and CHb, but example embodiments are not limited thereto, and the through-via 178 may extend at a constant inclination from an upper end to a lower end.

The first and second horizontal conductive layers 104 and 106 may be sequentially stacked and disposed on an upper surface of the plate layer 103 in a first region R1. The first and second horizontal conductive layers 104 and 106 may be included in a common source structure CS together with the plate layer 103, and may function as a common source line for the semiconductor device 100c. The first horizontal conductive layer 104 may be directly connected to a channel layer 140 in lower portions of the channel structures CHa and CHb.

The first and second horizontal conductive layers 104 and 106 may include a semiconductor material, and may include, for example, polycrystalline silicon. In this case, at least the first horizontal conductive layer 104 may be a layer doped with impurities of the same conductivity type as that of the plate layer 103. The second horizontal conductive layer 106 may be a doped layer or a layer including impurities diffused from the first horizontal conductive layer 104.

The horizontal insulating layer 105 may be disposed on the plate layer 103 on the same level as a level of the first horizontal conductive layer 104 in at least portions of an extension region R2 and first and second string select regions R2a and R2b. The horizontal insulating layer 105 may include first and second horizontal insulating layers stacked alternately on the plate layer 103. The horizontal insulating layer 105 may be layers remaining after a portion of the horizontal insulating layer 105 is replaced with the first horizontal conductive layer 104 during a manufacturing process of the semiconductor device 100c.

The horizontal insulating layer 105 may include silicon oxide, silicon nitride, silicon carbide, or silicon oxynitride. However, example embodiments are not limited thereto. The first horizontal insulating layers and the second horizontal insulating layers may include different insulating materials.

The substrate insulating layer 121 may be disposed to penetrate through the plate layer 103, the horizontal insulating layer 105, and the second horizontal conductive layer 106, in the edge region R3. The substrate insulating layer 121 may include an insulating material, for example, silicon oxide, silicon nitride, silicon carbide, or silicon oxynitride. However, example embodiments are not limited thereto.

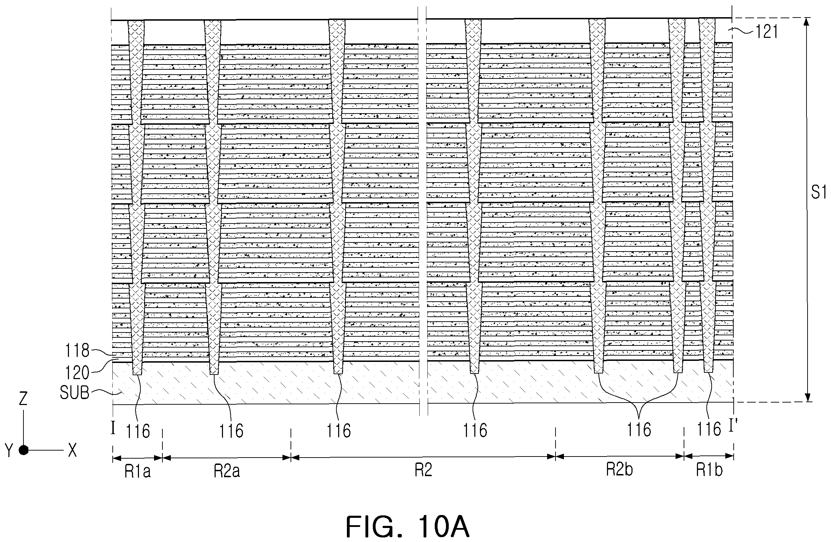

FIGS. 10A to 10K are schematic cross-sectional views illustrating a method of manufacturing a semiconductor device according to some example embodiments, and illustrate cross-sections corresponding to FIG. 2A.

Referring to FIG. 10A, first in the first semiconductor structure S1, sacrificial insulating layers 118 and interlayer insulating layers 120 may be formed up to an uppermost interlayer insulating layer 121 in the form in which the sacrificial insulating layers 118 and the interlayer insulating layers 120 are alternately stacked on a base substrate SUB. Vertical sacrificial structures 116 penetrating through a mold structure may be formed therein.

The base substrate SUB is a layer removed through a subsequent process and may be a semiconductor substrate such as a silicon (Si) wafer. A first mold stack structure of the mold structure may be first formed and portions of the vertical sacrificial structures 116 penetrating through the first mold stack structure may be formed, and then, a second mold stack structure may be formed and portions of the vertical sacrificial structures 116 penetrating through the second mold stack structure may be formed. Third and fourth mold stack structures and portions of the vertical sacrificial structures 116 may be formed in the same manner.

The sacrificial insulating layers 118 may be a layer replaced with the gate electrodes 130 (see FIG. 2A) through a subsequent process. The sacrificial insulating layers 118 may be formed of a material different from the interlayer insulating layers 120, and may be formed of a material that may be etched with etch selectivity under specific etching conditions with respect to the interlayer insulating layers 120. For example, the interlayer insulating layer 120 may be formed of at least one of silicon oxide and silicon nitride, and the sacrificial insulating layers 118 may be formed of a material different from the interlayer insulating layer 120 selected from silicon, silicon oxide, silicon carbide, and silicon nitride. In some example embodiments, thicknesses of the interlayer insulating layers 120 may not all be the same, and an uppermost interlayer insulating layer 121 may have a greater thickness than those of the other interlayer insulating layers 120. The thicknesses of the interlayer insulating layers 120 and the sacrificial insulating layers 118 and the number of films included therein may be variously changed from those illustrated.

The vertical sacrificial structures 116 may be formed in positions corresponding to the channel structures CHa and CHb and the support structures DH of FIG. 2A. For example, the vertical sacrificial structures 116 may be formed to have the same size as the channel structures CHa and CHb and the support structures DH. The vertical sacrificial structures 116 may include, for example, carbon (C), but example embodiments are not limited thereto.

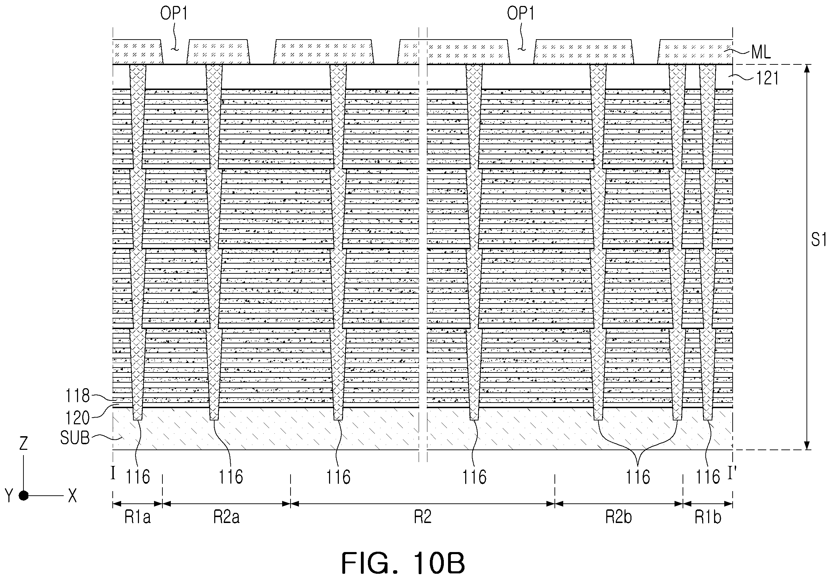

Referring to FIG. 10B, a mask layer ML having first openings OP1 may be formed on the uppermost interlayer insulating layer 121.

The mask layer ML may include a hard mask layer and a photoresist layer. The hard mask layer may include, for example, polycrystalline silicon. The first openings OP1 may be formed in a circular shape, an oval shape, or a shape similar thereto in regions corresponding to the contact plugs MC1a, MC1b and MC2 of FIG. 2A. When patterning the mask layer ML, a portion of the uppermost interlayer insulating layer 121 therebelow may be removed, but example embodiments are not limited thereto.

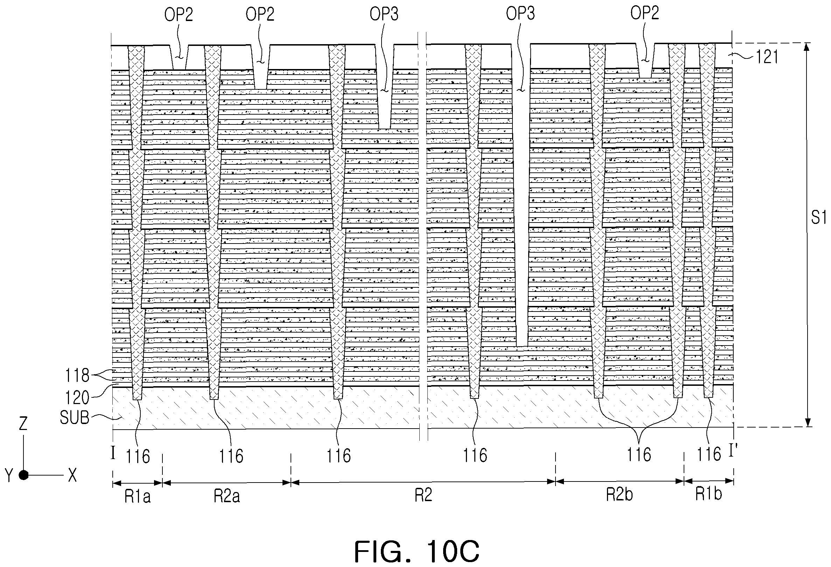

Referring to FIG. 10C, the mold structure may be etched using the mask layer ML to form second and third openings OP2 and OP3 and the mask layer ML may be removed.

The second and third openings OP2 and OP3 may be formed to extend from the first openings OP1 of the mask layer ML, respectively. The second and third openings OP2 and OP3 may be formed by repeatedly performing a plurality of etching processes of etching the mold structure to a desired (and/or alternatively predetermined) depth. In FIG. 10C, the sacrificial insulating layers 118 are illustrated as being exposed through bottom surfaces of the second and third openings OP2 and OP3, but example embodiments are not limited thereto, and portions of the upper interlayer insulating layers 120 thereon may remain.

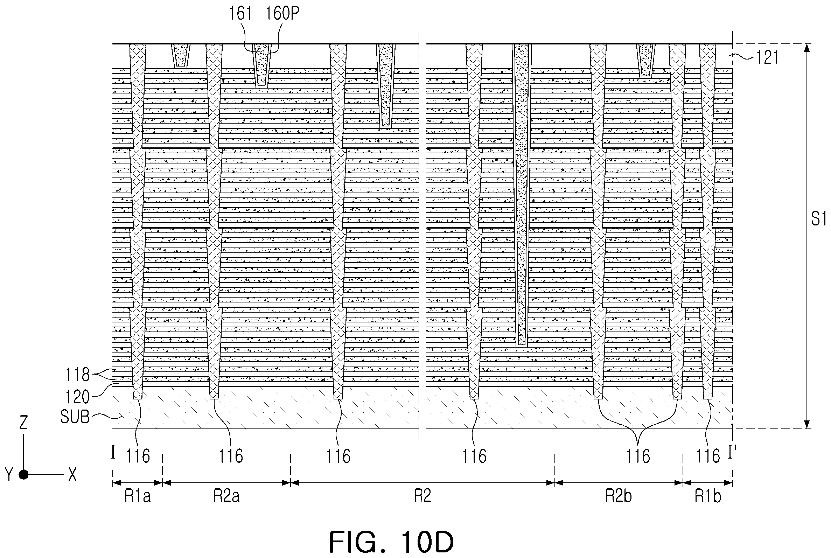

Referring to FIG. 10D, preliminary contact insulating layers 160P and contact sacrificial layers 161 may be formed in the second and third openings OP2 and OP3.

The preliminary contact insulating layers 160P may be conformally formed to cover sidewalls and bottom surfaces of the second and third openings OP2 and OP3. For example, the preliminary contact insulating layers 160P may be formed using an atomic layer deposition (ALD) or chemical vapor deposition (CVD) process.

The contact sacrificial layers 161 may be formed to fill the second and third openings OP2 and OP3 on the preliminary contact insulating layers 160P. The contact sacrificial layers 161 may include a material different from the preliminary contact insulating layers 160P, and may include, for example, carbon (C).

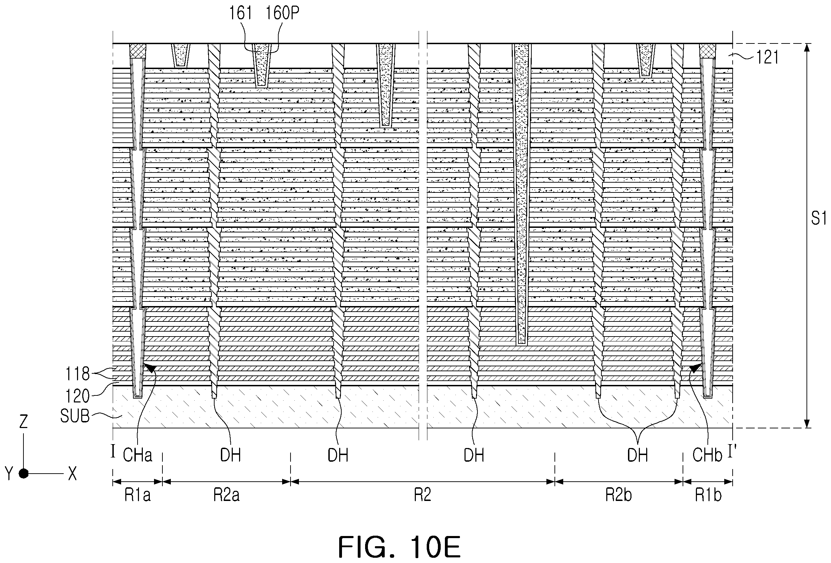

Referring to FIG. 10E, portions of the vertical sacrificial structures 116 may be removed and channel structures CHa and CHb may be formed.

A mask layer exposing only regions corresponding to the channel structures CHa and CHb in the first memory region R1a and the second memory region R1b may be formed, and channel holes may be formed by removing exposed vertical sacrificial structures 116. At least a portion of a channel dielectric layer 145, a channel layer 140, a channel buried insulating layer 147, and a channel pad 149 may be sequentially deposited in the channel holes, thus forming the channel structures CHa and CHb.

The channel dielectric layer 145 may be formed to have a substantially uniform thickness using the ALD or CVD process. In this operation, the channel dielectric layer 145 may be formed in whole or in part, and a portion extending to be perpendicular to the conductive layer 101 along the channel structures CHa and CHb may be formed in this operation. The channel layer 140 may be formed on the channel dielectric layer 145 in the channel holes. The channel buried insulating layer 147 is formed to fill the channel holes and may be formed of an insulating material. The channel pad 149 may be formed of a conductive material, and may be formed of, for example, polycrystalline silicon. However, example embodiments are not limited thereto.

Additionally, portions of the vertical sacrificial structures 116 may be removed and the support structures DH may be formed.

A mask layer exposing regions corresponding to the support structures DH may be formed in the first and second string select regions R2a and R2b and the extension region R2, and exposed vertical sacrificial structures 116 may be removed, thus forming dummy holes. A process of expanding the dummy holes may be performed by removing a portion of the mold structure around the dummy holes. The support structures DH may be formed by filling the expanded dummy holes with an insulating material.

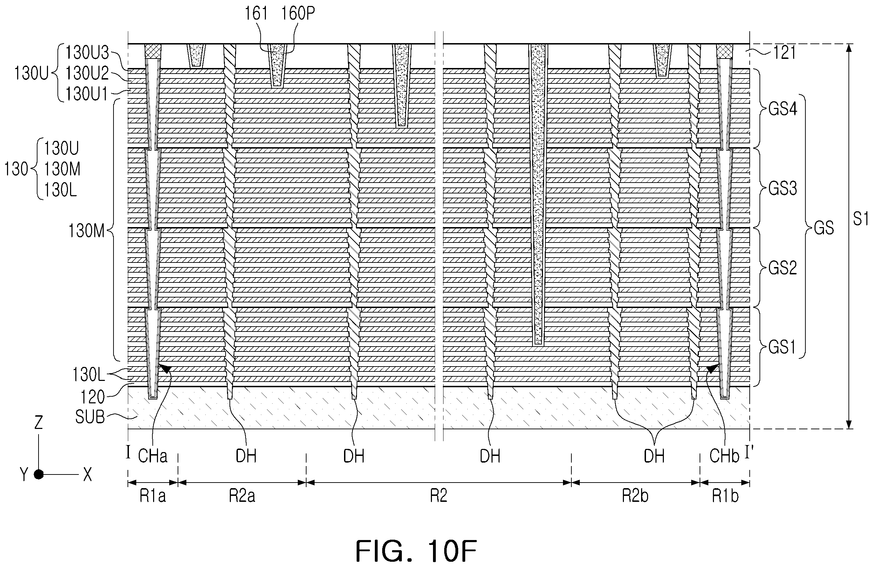

Referring to FIG. 10F, the sacrificial insulating layers 118 may be removed and gate electrodes 130 may be formed.

A separation opening for opening a region corresponding to the separation regions MS of FIGS. 2 and 4B may be formed. The separation opening may be formed by forming a plurality of vertical holes in a region in which the separation regions MS are formed, and then expanding the plurality of vertical holes through a cleaning process, and the like, to communicate with neighboring vertical holes. When the separation opening is formed by expansion of the plurality of vertical holes, a side surface of the separation opening may include continuous convex curved surfaces, but example embodiments are not limited thereto.

The sacrificial insulating layers 118 exposed through the separation openings may be removed. The sacrificial insulating layers 118 may be selectively removed with respect to the interlayer insulating layers 120, the channel structures CHa and CHb, the support structures DH, and the preliminary contact insulating layers 160P, for example, using wet etching.

The gate electrodes 130 may be formed by depositing a conductive material in regions from which the sacrificial insulating layers 118 have been removed. The conductive material may include a metal, polycrystalline silicon, or a metal silicide material. However, example embodiments are not limited thereto. In the gate electrodes 130, after forming diffusion barrier layers 131 (see FIG. 5A), the conductive material may be deposited to form the gate electrodes 130. In some example embodiments, a portion of the channel dielectric layer 145 may be formed first before forming the gate electrodes 130. Accordingly, a stack structure GS including the first to fourth stack structures GS1, GS2, GS3 and GS4 may be formed. After forming the gate electrodes 130, an insulating material may be deposited in the separation openings to form separation regions MS extending in the X-direction as illustrated in FIG. 2.

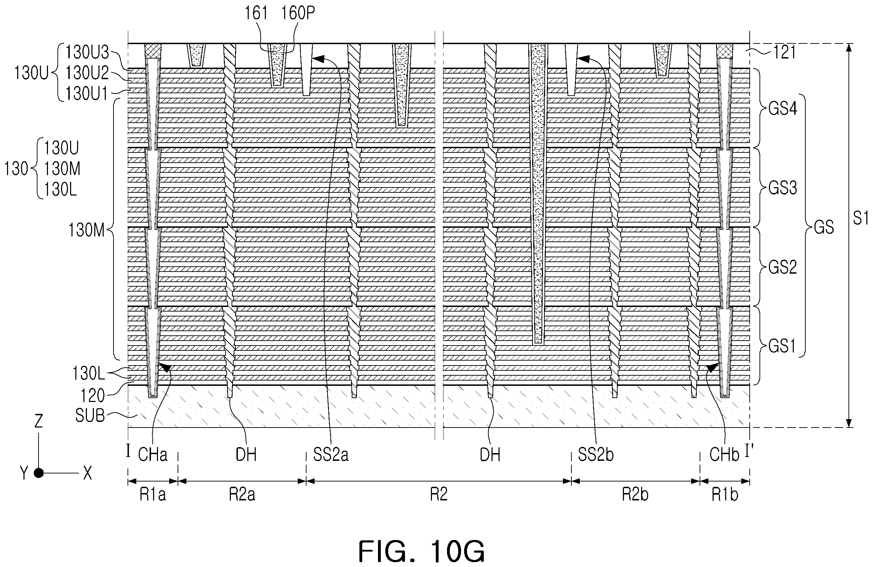

Referring to FIG. 10G, first and second insulating regions SS1a, SS1b, SS2a and SS2b penetrating through upper gate electrodes 130U1 to 130U3 may be formed.

Specifically, as illustrated in FIGS. 2 and 3, trenches removing the upper gate electrodes 130U1 to 130U3 and the interlayer insulating layer 120 in regions corresponding to the first insulating regions SS1a and SS1b and the second insulating regions SS2a and SS2b may be formed.

Between two adjacent separation regions MS, horizontal trenches corresponding to the first insulating regions SS1a and SS1b, first trenches may be formed by penetrating through the first to third upper gate electrodes 130U1 to 130U3 from an upper portion of the uppermost interlayer insulating layer 121 so as to extend in the first memory region R1a and the first string select region R2a in the X-direction and selectively cutting an upper portion of the fourth stack structure GS4.

Second trenches may be formed by penetrating through the first to third upper gate electrodes 130U1 to 130U3 from the upper portion of the uppermost interlayer insulating layer 121 so as to extend in the second memory region R1b and the second string select region R2b in the X-direction and selectively cutting the upper portion of the fourth stack structure GS4.

The first and second trenches may be formed to extend while cutting portions of the channel structures CHa and CHb in the first and second memory regions R1a and R1b.

Additionally, vertical trenches may be formed in regions corresponding to the second insulating regions SS2a and SS2b. The vertical trenches may be formed by extending in the Y-direction so as to separate between the extension region R2 and the first and second string select regions R2a and R2b, and may be formed to selectively cut the upper portion of the fourth stack structure GS4 so as to penetrate through the first to third upper gate electrodes 130U1 to 130U3 from the uppermost interlayer insulating layer 121. Accordingly, the first and second trenches and the vertical trenches do not extend to the memory gate electrodes 130M corresponding to the word line.

An insulating material may be deposited on the first and second trenches and the vertical trenches, thus forming first and second insulating regions SS1a, SS1b, SS2a and SS2b.

Accordingly, the upper gate electrodes 130U1 to 130U3 may be included in a plurality of sub-sections RS1 to RS8 by physically and electrically separating sections cut by the separation region MS and the first and second insulating regions SS1a, SS1b, SS2a and SS2b, in addition to a sub-region RS0 disposed in the extension region R2.

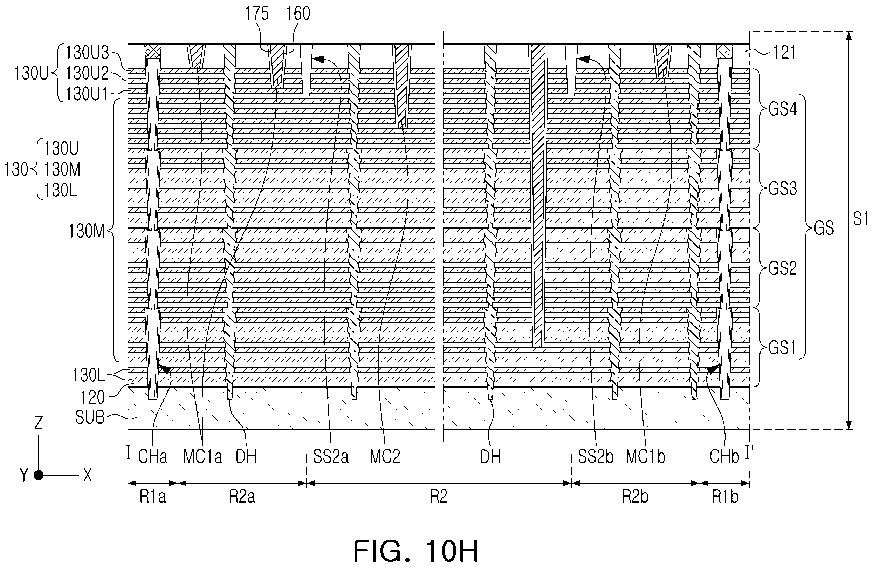

As illustrated in FIG. 10H, contact plugs MC1a, MC1b and MC2 may be formed. Specifically, after selectively removing the contact sacrificial layers 161 with respect to the preliminary contact insulating layers 160P, portions of exposed preliminary contact insulating layers 160P may be removed to form contact insulating layers 160.

That is, after removing the contact sacrificial layers 161, portions of the exposed preliminary contact insulating layers 160P may be removed from bottom surfaces. Upon removal of the preliminary contact insulating layers 160P, the exposed gate electrodes 130 may also be partially recessed from upper surfaces. Accordingly, the contact insulating layers 160 disposed only on sidewalls of the second and third openings OP2 and OP3 may be formed. The contact plugs MC1a, MC1b and MC2 may be formed by depositing a conductive material in the second and third openings OP2 and OP3. The contact plugs MC1a, MC1b and MC2 may be physically connected to the gate electrodes 130 therebelow.

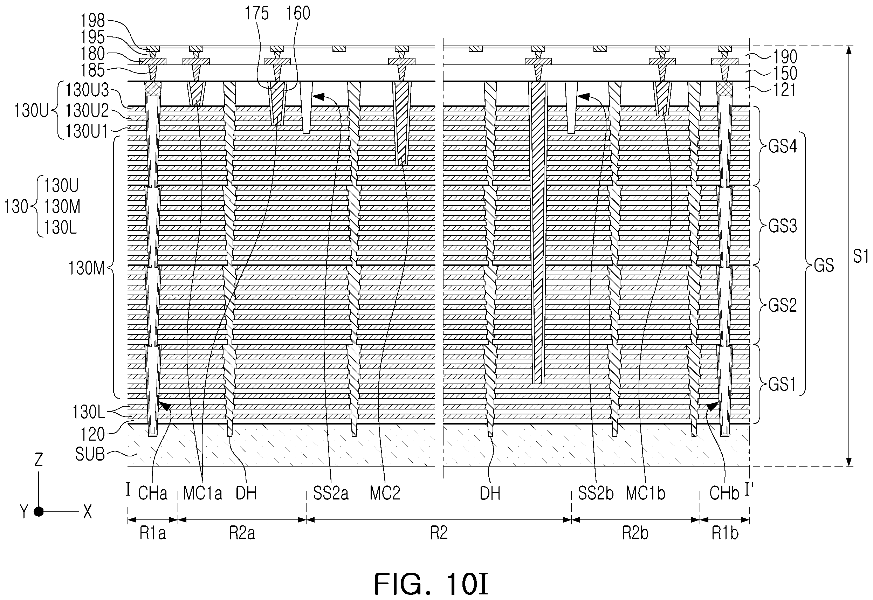

Referring to FIG. 10I, upper interconnection structures 185 and 180 and first bonding structures 195 and 198 may be formed on the stack structures GS1 to GS4.

After forming a cell region insulating layer 150, studs 185 and cell interconnection lines 180 may be formed.

The studs 185 may be formed by forming stud holes penetrating through the cell region insulating layer 150 and exposing the channel structures CHa and CHb and the contact plugs MC1a, MC1b and MC2, and then filling the stud holes with a conductive material. The cell interconnection lines 180 may be formed on the studs 185.

Next, the first bonding vias 195 and first bonding metal layers 198 included in the first bonding structures 195 and 198 may be formed by further forming an upper insulating layer 190 on the studs 185, partially removing a portion of the upper insulating layer 190, and depositing a conductive material on the removed portion. Upper surfaces of the first bonding metal layers 198 may be exposed from the upper insulating layer 190. Accordingly, a first semiconductor structure S1 may be prepared.

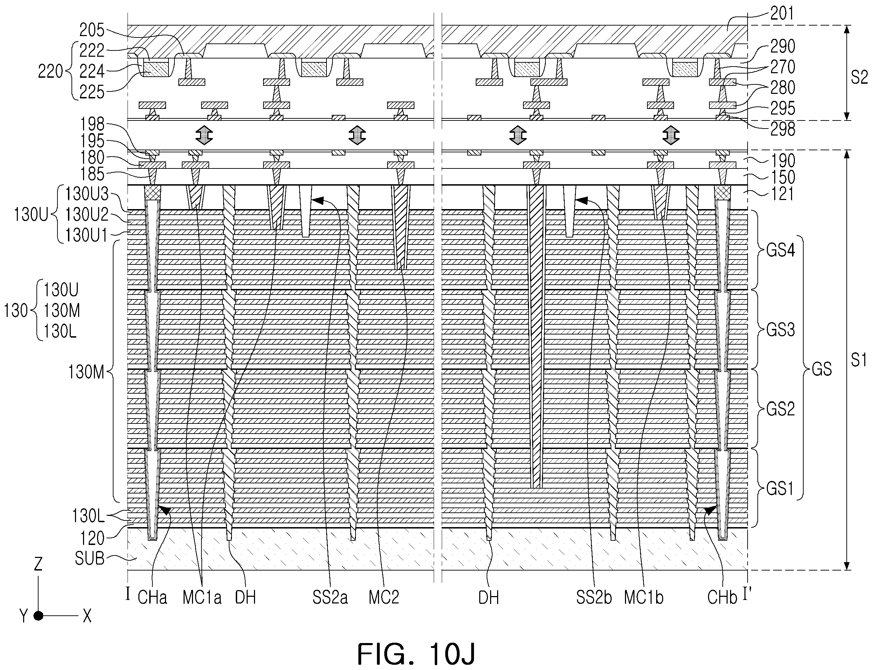

Referring to FIG. 10J, after forming a second semiconductor structure S2, the first semiconductor structure S1 and the second semiconductor structure S2 may be bonded.

The second semiconductor structure S2 may be prepared by forming circuit elements 220, circuit interconnection structures, and a second bonding structure on the substrate 201.

Device isolating layers 210 may be formed in the substrate 201, and a circuit gate dielectric layer 222 and a circuit gate electrode 225 may be sequentially formed on the substrate 201. The device isolating layers 210 may be formed by, for example, a shallow trench isolation

(STI) process. The circuit gate dielectric layer 222 and the circuit gate electrode 225 may be formed using ALD or CVD. The circuit gate dielectric layer 222 may be formed of silicon oxide, and the circuit gate electrode 225 may be formed of at least one of polycrystalline silicon or a metal silicide layer, but example embodiments are not limited thereto. A spacer layer 224 and source/drain regions 205 may be formed on both sidewalls of the circuit gate dielectric layer 222 and the circuit gate electrode 225. According to some example embodiments, the spacer layer 224 may be formed of a plurality of layers. The source/drain regions 205 may be formed by performing an ion implantation process.

Circuit contact plugs 270 of the circuit interconnection structure and second bonding vias 295 of the second bonding structure may be formed by partially forming a peripheral region insulating layer 290, partially etching and removing the peripheral region insulating layer 290, and filling a conductive material with the removed portion. Circuit interconnection lines 280 of the circuit interconnection structure and second bonding metal layers 298 of the second bonding structure may be formed by, for example, depositing a conductive material and then patterning the conductive material. The second bonding metal layers 298 may be formed so that lower surfaces thereof are exposed through the peripheral region insulating layer 290.

The peripheral region insulating layer 290 may be formed of a plurality of insulating layers. The peripheral region insulating layer 290 may be partially formed in each operation of forming the circuit interconnection structure and the second bonding structure. Through this operation, the second semiconductor structure S2 may be prepared.

The first semiconductor structure S1 and the second semiconductor structure S2 may be connected to each other by bonding the first bonding metal layers 198 and the second bonding metal layers 298 by applying pressure. At the same time, upper surfaces of the upper insulating layer 190 and the peripheral region insulating layers 290 may be bonded by pressure as bonding insulating layers. The second semiconductor structure S2 on the first semiconductor structure S1 may be inverted so that the second bonding metal layers 298 may face downwardly, and then bonding may be performed. The bonding may be performed by attaching an additional carrier substrate to one surface of the second semiconductor structure S2, for example, to one surface of the substrate 201.

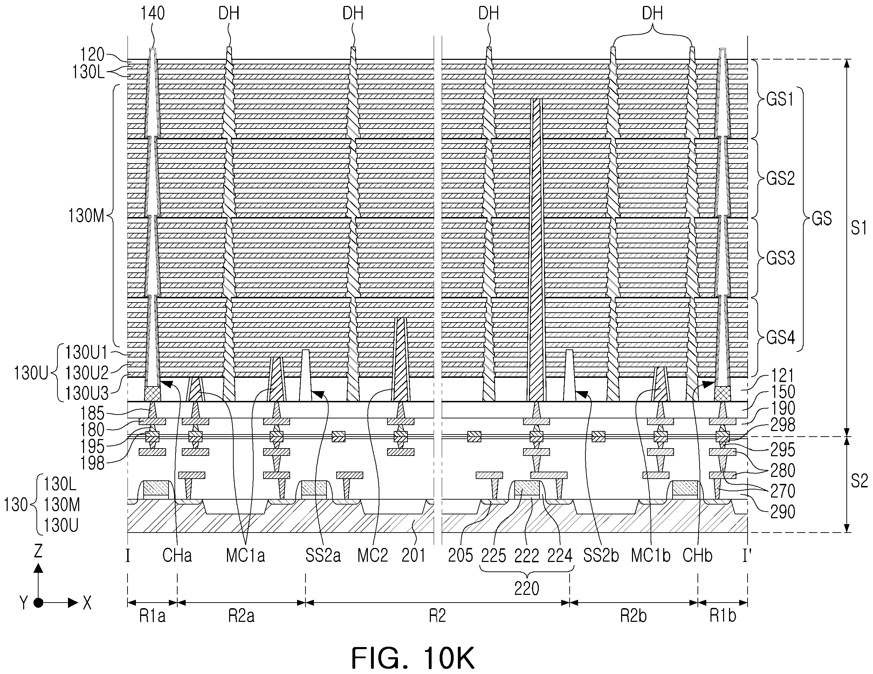

Referring to FIG. 10K, the base substrate SUB may be removed and the channel layers 140 may be exposed.

In a bonding structure of the first semiconductor structure S1 and the second semiconductor structure S2, the channel layers 140 may be exposed by removing the base substrate SUB and removing portions of the exposed channel dielectric layers 145 (see FIG. 5A).

Next, referring to FIG. 2A together, the semiconductor device 100 of FIG. 2A may be manufactured by forming the conductive layer 101 connected to the channel layers 140. In some example embodiments, the conductive layer 101 may be formed as a conformal layer along upper ends of the channel structures Cha and CHb and upper ends of the support structures DH.

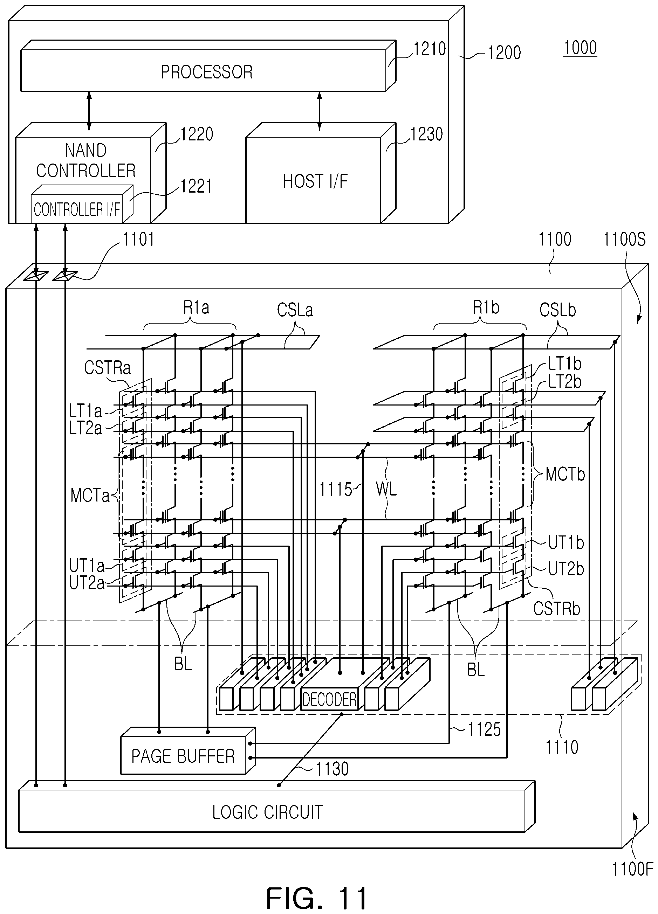

FIG. 11 is a view schematically illustrating a data storage system including a semiconductor device according to some example embodiments.

Referring to FIG. 11, a data storage system 1000 may include a semiconductor device 1100 and a controller 1200 electrically connected to the semiconductor device 1100. The data storage system 1000 may be a storage device including one or a plurality of semiconductor devices 1100 or an electronic device including a storage device. For example, the data storage system 1000 may be a solid state drive device (SSD) device, a universal serial bus (USB) device, a computing system, a medical device, or a communication device, including one or a plurality of semiconductor devices 1100. However, example embodiments are not limited thereto.

The semiconductor device 1100 may be a non-volatile memory device, for example, the NAND flash memory device described above with reference to FIGS. 1 to 9. The semiconductor device 1100 may include a first structure 1100F and a second structure 1100S on the first structure 1100F. In some example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may be disposed in the first memory region R1a and the second memory region R1b, respectively, and the memory cell strings CSTR of the first memory region R1a and the memory cell strings CSTR of the second memory region R1b may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously changed according to some example embodiments.

As illustrated in FIG. 1, the memory cell strings CSTR of the first memory region R1a and the memory cell strings CSTR of the second memory region R1b may be individually connected to first and second gate lower lines LL1a, LL2a, LL1b and LL2b separated from each other, common source lines CSLa and CSLb, first and second gate upper lines UL1a, UL2a, UL1b and UL2b. Accordingly, the individually connected memory cell strings CSTR may be selectively connected by an electrical signal from the decoder circuit 1110.

However, in the memory cell strings CSTR of the first memory region R1a and the memory cell strings CSTR of the second memory region R1b, the memory cell transistors MCTa and MCTb on the same level may be connected to the same word line WL, thus commonly transmitting, and receiving the electrical signal.

Each of these lines may be electrically connected to the decoder circuit 1110 through first connection interconnection lines 1115 extending from the first structure 1100F to the second structure 1100S. The bit lines BL may be electrically connected to the page buffer 1120 through second connection interconnection lines 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection interconnection line 1135 extending from the first structure 1100F to the second structure 1100S.

The controller 1200 may include a processor 1210, a NAND controller 1220, and a host interface 1230. According to some example embodiments, the data storage system 1000 may include a plurality of semiconductor devices 1100, and in this case, the controller 1200 may control the plurality of semiconductor devices 1100.

The processor 1210 may control an overall operation of the data storage system 1000, including the controller 1200. The processor 1210 may operate according to desired (and/or alternatively predetermined) firmware and may control the NAND controller 1220 to access the semiconductor device 1100. The NAND controller 1220 may include a NAND interface 1221 processing communication with the semiconductor device 1100. Through the NAND interface 1221, control commands for controlling the semiconductor device 1100, data to be recorded in the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving the control commands from the external host through the host interface 1230, the processor 1210 may control the semiconductor device 1100 in response to the control commands.

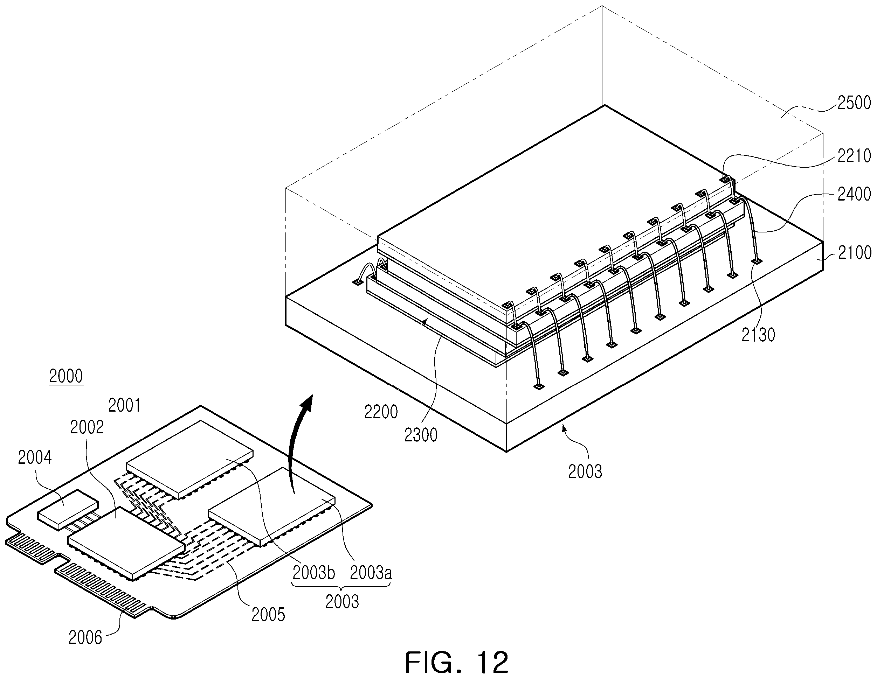

FIG. 12 is a perspective view schematically illustrating a data storage system including a semiconductor device according to some example embodiments.

Referring to FIG. 12, a data storage system 2000 may include a main board 2001, a controller 2002 mounted on the main board 2001, one or more semiconductor packages 2003, and a DRAM 2004. The semiconductor package 2003 and the DRAM 2004 may be connected to the controller 2002 through interconnection patterns 2005 formed on the main board 2001.

The main board 2001 may include a connector 2006 including a plurality of pins coupled to the external host. The number and arrangement of the plurality of pins in the connector 2006 may vary depending on the communication interface between the data storage system 2000 and the external host. In some example embodiments, data storage system 2000 may communicate with the external host according to any one of the interfaces, for example, universal serial bus (USB), peripheral component interconnect express (PCI-Express), serial advanced technology attachment (SATA), and M-Phy for universal flash storage (UFS). In some example embodiments, the data storage system 2000 may operate with power supplied from the external host through the connector 2006. The data storage system 2000 may further include a power management integrated circuit (PMIC) configured to distribute power supplied from the external host to the controller 2002 and the semiconductor package 2003.

The controller 2002 may record data in the semiconductor package 2003 or read data from the semiconductor package 2003, and may improve the operating speed of the data storage system 2000.

The DRAM 2004 may be a buffer memory for alleviating a speed difference between the semiconductor package 2003, which is a data storage space, and the external host. The DRAM 2004 included in the data storage system 2000 may also operate as a type of cache memory, and a space for temporarily storing data may be provided during a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may include a plurality of semiconductor chips 2200. Each of the first and second semiconductor packages 2003a and 2003b, a package substrate 2100, semiconductor chips 2200 on the package substrate 2100, adhesive layers 2300 disposed on lower surfaces of each of the semiconductor chips 2200, a connection structure 2400 electrically connecting the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each of semiconductor chips 2200 may include an input/output pad 2210. The input/output pad 2210 may correspond to the input/output pad 1101 of FIG. 11. Each of the semiconductor chips 2200 may include the semiconductor device described above with reference to FIGS. 1 to 9.

In some example embodiments, the connection structure 2400 may be a bonding wire configured to electrically connect the input/output pad 2210 and the package upper pads 2130. Accordingly, in each of the first and second semiconductor packages 2003a and 2003b, the semiconductor chips 2200 may be electrically connected to each other using a bonding wire method and may be electrically connected to the package upper pads 2130 of the package substrate 2100. According to some example embodiments, in each of the first and second semiconductor packages 2003a and 2003b, the semiconductor chips 2200 may be electrically connected to each other by a connection structure including a Through-Silicon Via (TSV), instead of the connection structure 2400 of the bonding wire method.

In some example embodiments, the controller 2002 and the semiconductor chips 2200 may be included in one package. In some example embodiments, the controller 2002 and the semiconductor chips 2200 may be mounted on an additional interposer substrate different from the main board 2001, and the controller 2002 and the semiconductor chips 2200 may be connected to each other through interconnection lines formed on the interposer substrate.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

## Claims

1. A semiconductor device (100), comprising:
a conductive layer (101);
a stack structure (GS) including lower gate electrodes (130L), memory gate electrodes (130M), and upper gate electrodes (130U) stacked sequentially in a first direction (Z) on the conductive layer (101) and spaced apart from each other in a first region (R1a), a second region (R1b), and an extension region (R2) between the first region (R1a) and the second region (R1b), the first direction (Z) being perpendicular to an upper surface of the conductive layer (101);
first channel structures (CHa) and second channel structures (CHb) penetrating through the stack structure (GS) and extending in the first direction (Z), respectively, in the first region (R1a) and the second region (R1b);
separation regions (MS) extending in a second direction (X), the second direction (X) being perpendicular to the first direction (Z);
the separation regions (MS) penetrating through the stack structure (GS) in the first region (R1a), the extension region (R2), and the second region (R1b), and spaced apart from each other in a third direction (Y), the third direction (Y) being perpendicular to the first and second directions (Z, X);
first insulating regions (SS1a, SS1b) penetrating through the upper gate electrodes (130U) in each of the first and second regions (R1a, R1b) between the separation regions (MS) and extending in the second direction (X);
second insulating regions (SS2a, SS2b) separating the upper gate electrodes (130U) into first upper gate electrodes and second upper gate electrodes, and extending in the third direction (Y) between the first region (R1a) and the extension region (R2) and further between the second region (R1b) and the extension region (R2);
first string select contact plugs (MC1a) in contact with at least one of the first upper gate electrodes and electrically connected to least one of the first upper gate electrodes, respectively, in the first region (R1a);
second string select contact plugs (MC1b) in contact with at least one of the second upper gate electrodes and electrically connected to the least one of second upper gate electrodes, respectively, in the second region (R1b); and
word line contact plugs (MC2) penetrating through the upper gate electrodes (130U) and electrically connected to one of the memory gate electrodes (130M) or one of the lower gate electrodes (130L), respectively, in the extension region (R2).

2. The semiconductor device (100) of claim 1, wherein the number of first string select contact plugs (MC1a) in the first region (R1a) is the same as the number of second string select contact plugs (MC1b) in the second region (R1b).

3. The semiconductor device (100) of claim 1 or 2, wherein the first upper gate electrodes and the second upper gate electrodes are separated into a plurality of sub-sections by the separation regions (MS), the first insulating regions (SS1a, SS1b), and the second insulating regions (SS2a, SS2b), and
the number of first string select contact plugs (MC1a) or the number of second string select contact plugs (MC1b) in each of the plurality of sub-sections is the same.

4. The semiconductor device (100) of claim 3, wherein the first string select contact plugs (MC1a) or the second string select contact plugs (MC1b) in at least one of the plurality of sub-sections are in contact with the upper gate electrodes (130U) respectively.

5. The semiconductor device (100) of any one of claims 1 to 4, wherein each of the gate electrodes (130) connected to the word line contact plugs (MC2) electrically connects the first channel structures (CHa) and the second channel structures (CHb) of the first region (R1a) and the second region (R1b) together.

6. The semiconductor device (100) of any one of claims 1 to 5, wherein the word line contact plugs (MC2) are respectively connected to the gate electrodes (130) on different levels, among the memory gate electrodes (130M) and the lower gate electrodes (130L).

7. The semiconductor device (100) of any one of claims 1 to 6, further comprising:
a side insulating layer (160) surrounding side surfaces of the word line contact plugs (MC2); and
interlayer insulating layers (120) alternately stacked with the gate electrodes (130) and an uppermost interlayer insulating layer (121) on an uppermost upper gate electrode (130U3).

8. The semiconductor device (100) of claim 7, wherein the first and second string select contact plugs (MC1a, MC1b) include studs penetrating through the uppermost interlayer insulating layer (121) to contact an upper surface of the uppermost upper gate electrode (130U3).

9. The semiconductor device (100) of claim 7 or 8, wherein in the first region (R1a) and the second region (R1b), the upper gate electrodes (130U) include a staircase-shaped step structure (GP) including contact regions in contact with the first and second string select contact plugs (MC1a, MC1b), and
the first and second string select contact plugs (MC1a, MC1b) include studs in contact with the contact regions, respectively.

10. The semiconductor device (100) of claim 9, wherein in the extension region (R2), the upper gate electrodes (130U) include a dummy step structure (GP) corresponding to the staircase-shaped step structure (GP) of the first region (R1a) and the second region (R1b).

11. The semiconductor device (100) of claim 10, wherein a width of the staircase-shaped step structure (GP) in the first region (R1a) and the second region (R2a) is greater than a width of the dummy step structure (GP) in the extension region(R2).

12. The semiconductor device (100) of claim 1, wherein each of the word line contact plugs (MC2) includes a first plug conductive layer (175) and a first contact barrier layer (172) on a side surface and a lower surface of the first plug conductive layer (175), and
a lower surface of the first contact barrier layer (172) is in contact with one of the gate electrodes (130).

13. The semiconductor device (100) of claim 12, wherein each of the first and second string select contact plugs (MC1a, MC1b) includes a second plug conductive layer (175) and a second contact barrier layer (172) on a side surface and a lower surface of the second plug conductive layer (175), and
a lower surface of the second contact barrier layer (172) is in contact with one of the first or second upper gate electrodes(130U).

14. The semiconductor device (100) of claim 1,
wherein each of the memory gate electrodes (130M) and the lower gate electrodes (130L) extend in the first region (R1a), the extension region (R2), and the second region (R1b) and are spaced apart in the first direction (Z) from the first insulating regions (SS1a, SS1b) and the second insulating regions (SS2a, SS2b.

15. A data storage system (1000, 2000), comprising:
a semiconductor storage device including a first semiconductor structure including circuit elements (220), a second semiconductor structure according to any preceding claim, and an input/output pad (1101, 2210) electrically connected to the circuit elements (220);
a controller (1200, 1220, 2002) electrically connected to the semiconductor storage device through the input/output pad (1101, 2210) and configured to control the semiconductor storage device.
